(19) Europäisches Patentamt / European Patent Office / Office européen des brevets

(11) **EP 3 048 448 B1**

(12) **FASCICULE DE BREVET EUROPEEN**

(45) Date de publication et mention de la délivrance du brevet:
**17.04.2024 Bulletin 2024/16**

(21) Numéro de dépôt: **16152155.4**

(22) Date de dépôt: **21.01.2016**

(51) Classification Internationale des Brevets (IPC):
**G01R 19/25** (2006.01)  **G01R 21/133** (2006.01)
**G01R 22/06** (2006.01)  **G01R 22/10** (2006.01)

(52) Classification Coopérative des Brevets (CPC):
**G01R 19/2509; G01R 21/133; G01R 22/10;**
G01R 22/063

(54) **DISPOSITIF ET PROCÉDÉ DE SURVEILLANCE D'UNE TENSION OU D'UN COURANT, SYSTÈME DE SURVEILLANCE D'UN TABLEAU ÉLECTRIQUE, ARMOIRE ÉLECTRIQUE ET POSTE DE TRANSFORMATION ASSOCIÉS**

VERFAHREN UND VORRICHTUNG ZUR ÜBERWACHUNG EINER SPANNUNG ODER EINES STROMS, ENTSPRECHENDES ÜBERWACHUNGSSYSTEM EINER ELEKTRISCHEN SCHALTTAFEL, ENTSPRECHENDER SCHALTSCHRANK UND ENTSPRECHENDE TRANSFORMATOREINHEIT

DEVICE AND METHOD FOR MONITORING A VOLTAGE OR A CURRENT, SYSTEM FOR MONITORING AN ELECTRICAL PANEL, RELATED ELECTRICAL CABINET AND TRANSFORMER SUBSTATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.01.2015 FR 1550524**

(43) Date de publication de la demande:
**27.07.2016 Bulletin 2016/30**

(73) Titulaire: **Schneider Electric Industries SAS**
**92500 Rueil-Malmaison (FR)**

(72) Inventeurs:
• **MOLLIER, Christophe**
**38050 GRENOBLE Cedex 09 (FR)**
• **COUTELOU, Olivier**
**38050 GRENOBLE Cedex 09 (FR)**
• **GAILLARD, Maxime**
**38050 GRENOBLE Cedex 09 (FR)**
• **SILLANS, Damien**
**38050 GRENOBLE Cedex 09 (FR)**

(74) Mandataire: **Lavoix**
**62, rue de Bonnel**
**69448 Lyon Cedex 03 (FR)**

(56) Documents cités:
EP-A1- 2 685 267   EP-A1- 2 816 360
EP-A1- 2 873 981   WO-A1-2013/017663
FR-A1- 2 991 057

EP 3 048 448 B1

**Description**

La présente invention concerne un dispositif électronique de surveillance d'une grandeur électrique parmi une tension et une intensité relative à un courant alternatif circulant dans un conducteur électrique, le courant alternatif comportant au moins une phase.

Le dispositif de surveillance comprend un module de mesure configuré pour mesurer au moins une valeur de la grandeur électrique, un émetteur-récepteur radioélectrique, et un module d'émission relié à l'émetteur-récepteur radioélectrique.

La présente invention concerne également un système électronique de surveillance d'un tableau électrique comportant au moins un conducteur électrique primaire de départ et au moins un conducteur électrique secondaire de départ, chaque conducteur secondaire de départ étant connecté électriquement à un conducteur primaire de départ correspondant.

Le système de surveillance comprend de tels dispositifs de surveillance, à savoir un premier dispositif électronique de surveillance de la tension de chaque conducteur électrique primaire de départ, et au moins un deuxième dispositif électronique de surveillance de l'intensité du courant alternatif circulant dans chaque conducteur électrique secondaire.

La présente invention concerne également une armoire électrique comprenant un tableau électrique comportant des conducteurs électriques de départ, et un tel système de surveillance.

La présente invention concerne également un poste de transformation d'un courant électrique présentant une première tension alternative en un courant électrique présentant une deuxième tension alternative, ce poste de transformation comprenant une telle armoire électrique, un tableau d'arrivée comportant au moins un conducteur électrique d'arrivée propre à être relié à un réseau électrique, le conducteur d'arrivée présentant la première tension alternative, le tableau de l'armoire formant un tableau de départ dont les conducteurs de départ correspondants présentent la deuxième tension alternative. Le poste de transformation comporte en outre un transformateur électrique connecté entre le tableau d'arrivée et le tableau de départ, le transformateur étant propre à transformer le courant présentant la première tension alternative en le courant présentant la deuxième tension alternative.

La présente invention concerne également un procédé de surveillance d'une grandeur électrique parmi une tension et une intensité relative à un courant alternatif circulant dans un conducteur électrique.

On connaît du document WO 2013/017663 A1 un système de surveillance du type précité. Ce système de surveillance permet en particulier de mesurer l'énergie électrique du courant circulant dans des conducteurs secondaires reliés à un conducteur primaire, les conducteurs secondaires correspondant à des conducteurs de départ d'un tableau de départ et présentant sensiblement la même tension que le conducteur primaire. Le module primaire forme un dispositif de surveillance de la tension du conducteur primaire, et chaque module secondaire forme un dispositif de surveillance de l'intensité du courant circulant dans le conducteur secondaire correspondant.

Le module primaire mesure la tension du conducteur primaire, et transmet avec une période d'émission un premier message contenant une donnée de synchronisation et des valeurs représentatives de la tension. Pour cela, le module primaire calcule deux tables de corrélation couvrant chacune une période de tension. Le module primaire échantillonne ensuite la tension pendant une période de tension, puis calcule, à partir des tables de corrélation, la décomposition en série de Fourier de la tension mesurée sur cette période de tension. Les coefficients de Fourier calculés sont ensuite inclus dans le premier message. Chaque module secondaire se synchronise alors à l'aide de la donnée de synchronisation reçue ; mesure, de manière synchronisée avec le module primaire, les coefficients de Fourier de l'intensité du courant circulant dans le conducteur secondaire correspondant ; puis calcule l'énergie du courant circulant dans ledit conducteur secondaire à l'aide des valeurs mesurées d'intensité et des valeurs de tension contenues dans le premier message. Chaque module secondaire envoie ensuite, à destination d'un module de centralisation et selon un mécanisme de jeton distribué entre les modules secondaires, un deuxième message contenant l'identifiant du module secondaire correspondant et l'énergie calculée par le module secondaire, par exemple sous forme de différentes valeurs de compteurs d'énergie.

Toutefois, ce système de surveillance n'est pas adapté à des réseaux dans lesquels la tension et/ou la fréquence varient de manière notable, tels que les réseaux électriques insulaires. En effet, la mesure de la tension est faite, pour chaque période d'émission, sur une seule période de tension qu'on considère être représentative, la période d'émission correspondant à plusieurs périodes de tension. La période d'émission est, par exemple, égale à 1 seconde, alors que la période de tension est généralement égale à 16,66 millisecondes (ms) aux Etats-Unis et à 20 ms en Europe. La mesure de la tension est donc effectuée sur une brève partie de la période d'émission.

Le document FR 2 991 057 A1 décrit un système de mesure de l'énergie électrique d'un courant alternatif.

Le but de l'invention est de proposer des dispositifs de surveillance de la tension, et respectivement de l'intensité d'un courant alternatif circulant dans un conducteur électrique, et un système de surveillance comprenant de tels dispositifs, permettant de remédier au problème précité.

A cet effet, l'invention a pour objet un dispositif électronique de surveillance selon la revendication 1.

Avec le dispositif de surveillance selon l'invention, l'énergie électrique est calculée de manière plus précise et plus rapide. Les première et deuxième tables sont calculées pour toute la période d'émission, et le calcul de l'énergie électrique prend donc en compte les variations de la tension et/ou de l'intensité sur l'ensemble de la période d'émission. En outre, l'utilisation des première et deuxième tables permet de réduire le temps de calcul de l'énergie électrique.

Avec le système de surveillance de l'état de la technique, la tension est mesurée sur une seule période de tension, et est considérée comme ne variant pas sur le reste de la période d'émission.

Suivant d'autres aspects avantageux de l'invention, le dispositif électronique de surveillance est selon l'une quelconque des revendications 2 à 8.

L'invention a également pour objet un système électronique de surveillance d'un tableau électrique selon la revendication 9.

Suivant d'autres aspects avantageux de l'invention, le système électronique de surveillance est selon l'une quelconque des revendications 10 à 12.

L'invention a également pour objet une armoire électrique selon la revendication 13.

L'invention a également pour objet un poste de transformation selon la revendication 14.

L'invention a également pour objet un procédé de surveillance d'une grandeur électrique selon la revendication 15.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un poste de transformation comprenant un premier tableau, un deuxième tableau connecté au premier tableau par l'intermédiaire d'un transformateur et un système de surveillance de l'énergie électrique du courant circulant dans des conducteurs de départ du deuxième tableau,
- la figure 2 est une représentation schématique du système de surveillance de la figure 1, le système de surveillance comprenant un premier dispositif de mesure de la tension, une pluralité de deuxièmes dispositifs de mesure de l'intensité et un dispositif de centralisation,

- la figure 3 est une représentation schématique du deuxième dispositif de la figure 2,
- la figure 4 est un organigramme des étapes d'un procédé de surveillance selon l'invention, mises en oeuvre par le premier dispositif de la figure 2,
- la figure 5 est un organigramme des étapes du même procédé de surveillance, mises en oeuvre par les deuxièmes dispositifs des figures 2 et 3,
- la figure 6 est un organigramme des étapes du même procédé de surveillance, mises en oeuvre par le dispositif de centralisation de la figure 2,
- la figure 7 est un chronogramme représentant les instants d'émission et de réception d'un premier message, celui-ci étant émis par le premier dispositif à destination des deuxièmes dispositifs,

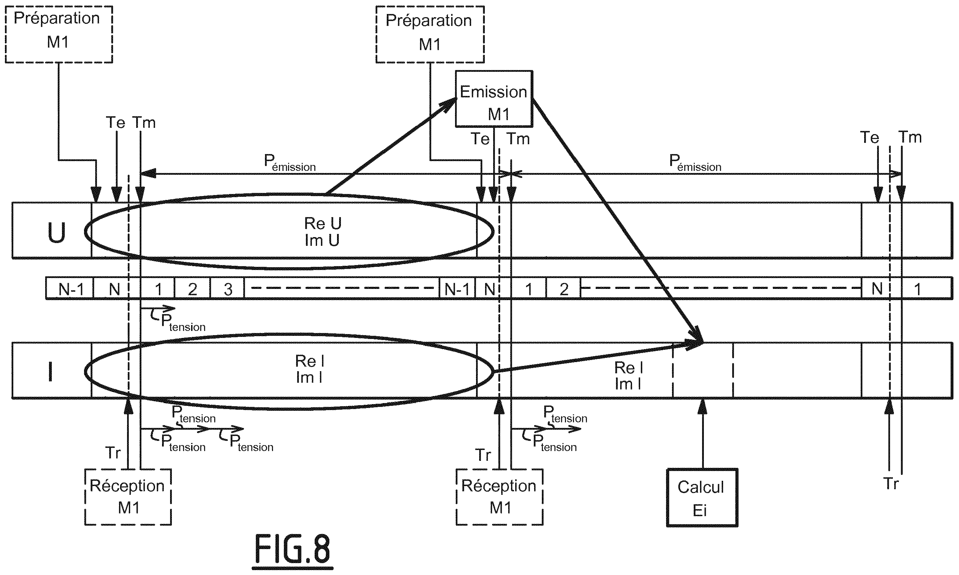

- la figure 8 est un chronogramme représentant les périodes temporelles pour lesquelles des coefficients d'une décomposition en série de Fourier de la tension, et respectivement de l'intensité, sont déterminés et également les instants temporels de préparation du premier message, d'émission du premier message et de calcul de l'énergie électrique, correspondant à un premier mode de réalisation, et
- la figure 9 est un chronogramme représentant les périodes temporelles pour lesquelles des coefficients d'une décomposition en série de Fourier de la tension, et respectivement de l'intensité, sont déterminés et également les instants temporels de préparation du premier message, d'émission du premier message et de calcul de l'énergie électrique, correspondant à un autre mode de réalisation.

Dans la suite de la description, l'expression « sensiblement égal à » définit une relation d'égalité à plus ou moins 10 %, de préférence à plus ou moins 5 %.

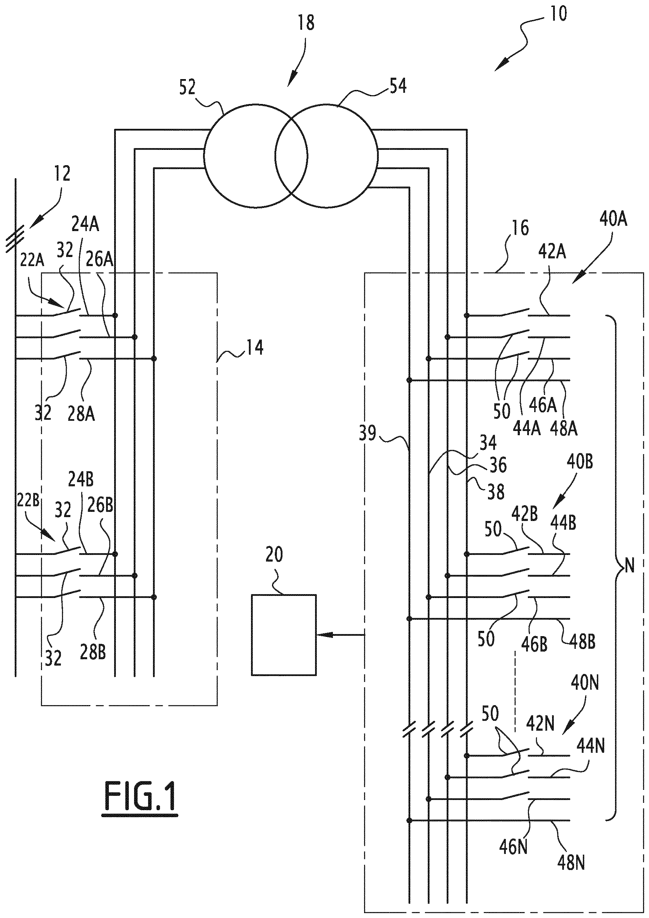

Sur la figure 1, un poste de transformation 10 connecté à un réseau électrique 12 comprend un premier tableau 14, également appelé tableau d'arrivée, un deuxième tableau 16, également appelé tableau de départ, un transformateur électrique 18 connecté entre le premier tableau et le deuxième tableau et un système 20 de surveillance du deuxième tableau.

En variante, une armoire électrique, non représentée, comporte le deuxième tableau 16 et le système de surveillance 20. Autrement dit, l'armoire électrique comporte les éléments du poste de transformation 10 à l'exception du transformateur électrique 18 et du premier tableau 14, le deuxième tableau 16 étant par exemple alimenté directement en basse tension.

Le poste de transformation 10 est propre à transformer le courant électrique délivré par le réseau 12 et présentant une première tension alternative, en un courant électrique présentant une deuxième tension alternative.

Le réseau électrique 12 est un réseau alternatif, tel qu'un réseau triphasé. Le réseau électrique 12 est, par exemple, un réseau moyenne tension, c'est-à-dire de tension supérieure à 1 000 V et inférieure à 50 000 V. La première tension triphasée est alors une moyenne tension. En variante, le réseau électrique 12 est un réseau haute tension, c'est-à-dire de tension supérieure à 50 000 V.

Le premier tableau 14 comporte plusieurs arrivées 22, chaque arrivée 22 comportant un premier 24A, 24B, un deuxième 26A, 26B, et un troisième 28A, 28B conducteurs d'arrivée. Chaque premier, deuxième, troisième conducteur d'arrivée 24A, 24B, 26A, 26B, 28A, 28B est relié au réseau électrique par l'intermédiaire d'un disjoncteur d'arrivée 32 respectif. Le courant triphasé circulant dans les conducteurs d'arrivée 24A, 24B, 26A, 26B, 28A, 28B correspondants présente la première tension triphasée.

Le deuxième tableau 16 comprend un premier 34, un deuxième 36, un troisième 38 et un quatrième 39 conducteurs primaires et une pluralité N de départs 40A, 40B, ...40N, à savoir un premier départ 40A, un deuxième départ 40B, ..., un Nième départ 40N, chaque départ 40A, 40B, ..., 40N étant propre à délivrer une tension triphasée.

Chaque départ 40A, 40B, 40N est un départ basse tension, c'est-à-dire de tension inférieure à 1 000 V. La deuxième tension triphasée est alors une basse tension. En variante, chaque départ 40A, 40B, ..., 40N est un départ moyenne tension, c'est-à-dire de tension est supérieure à 1 000 V et inférieure à 50 000 V.

Le premier départ 40A comporte un premier 42A, un deuxième 44A, un troisième 46A et un quatrième 48A conducteurs secondaires et trois disjoncteurs de départ 50. Les premier, deuxième et troisième conducteurs secondaires 42A, 42B, 42C sont respectivement reliés aux premier, deuxième et troisième conducteurs primaires 34, 36, 38 par l'intermédiaire d'un disjoncteur de départ 50 correspondant. Le quatrième conducteur secondaire 48A est directement connecté au quatrième conducteur primaire 39.

Les conducteurs primaires de départ 34, 36, 38 et les conducteurs secondaires de départ 42A, 44A, 46A correspondants présentent sensiblement la même tension, à savoir respectivement une première tension U1, une deuxième tension U2 et une troisième tension U3 correspondant aux trois phases de la deuxième tension triphasée.

Les autres départs 40B, ...40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte un enroulement primaire 52 connecté au premier tableau 14 et un enroulement secondaire 54 connecté au deuxième tableau 16.

Le système de surveillance 20 est configuré pour surveiller le deuxième tableau 16, notamment pour calculer l'énergie électrique du courant circulant dans le ou chaque conducteur secondaire de départ 42A, 44A, 46A, 42B, 44B, 46B, ..., 42N, 44N, 46N.

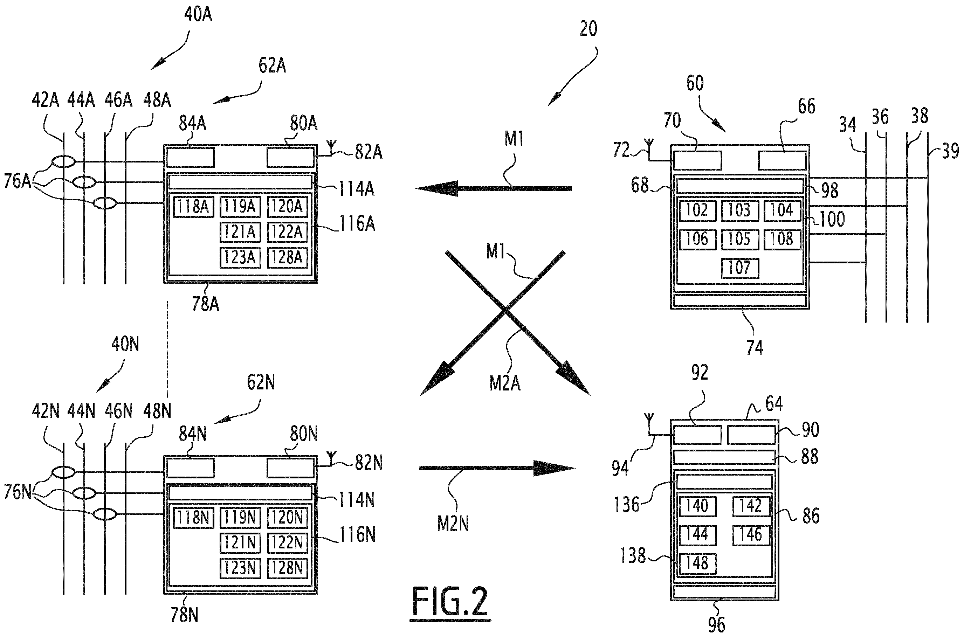

Le système de surveillance 20, visible sur la figure 2, comprend un premier dispositif électronique 60 de surveillance de la tension U1, U2, U3 de chaque conducteur électrique primaire de départ 34, 36, 38, une pluralité N de deuxièmes dispositifs électroniques 62A, 62B, ..., 62N de surveillance de l'intensité I1A, ..., I3N du courant alternatif circulant dans chaque conducteur électrique secondaire 42A, ..., 46N, et un dispositif électronique de centralisation 64.

Le premier dispositif 60 comporte un module 66 de mesure de la tension du courant circulant dans le conducteur primaire 34, 36, 38 correspondant, et une unité 68 de traitement d'informations. Le premier dispositif 60 comporte également un émetteur-récepteur radioélectrique 70, une antenne radioélectrique 72, et un module 74 d'alimentation électrique du module de mesure, de l'unité de traitement d'informations et de l'émetteur-récepteur radioélectrique.

Le deuxième dispositif avec la référence 62A comporte, pour chacun des premier 42A, deuxième 44A et troisième 46A conducteurs secondaires, un capteur 76A de l'intensité du courant circulant dans le conducteur secondaire 42A, 44A, 46A correspondant. Le deuxième dispositif 62A comporte une unité 78A de traitement d'informations, un émetteur-récepteur radioélectrique 80A, et une antenne radioélectrique 82A. Le deuxième dispositif 62A comporte également un module 84A d'alimentation électrique de l'unité de traitement d'informations et de l'émetteur-récepteur radioélectrique. Le deuxième dispositif 62A est identifié par un numéro unique, également appelé identifiant.

Les autres deuxièmes dispositifs 62B, ..., 62N sont identiques au deuxième dispositif 62A décrit précédemment, et comportent les mêmes éléments en remplaçant à chaque fois la lettre A par la lettre B, ..., N correspondante concernant les références des éléments. Chacun des autres deuxièmes dispositifs 62B, ..., 62N présente également un identifiant unique.

Le dispositif de centralisation 64 comporte une unité 86 de traitement d'informations, une base de données 88 et une interface homme-machine 90. Le dispositif de centralisation 64 comporte un émetteur-récepteur radioélectrique 92, une antenne radioélectrique 94 et un module 96 d'alimentation électrique de l'unité de traitement d'informations, de la base de données, de l'interface homme-machine et de l'émetteur-récepteur radioélectrique.

Le module de mesure 66 est propre à mesurer la première tension U1 de la phase circulant à travers le premier conducteur primaire 34, la deuxième tension U2 de la phase circulant à travers le deuxième conducteur primaire 36, et la troisième tension U3 de la phase circulant à travers le troisième conducteur primaire 38. Le module de mesure 66 est également propre à mesurer la fréquence F de la tension triphasée circulant à travers les conducteurs primaires 34, 36, 38.

L'unité de traitement d'informations 68 comporte un processeur 98 et une mémoire 100 apte à stocker un premier logiciel 102 d'acquisition de valeurs des tensions U1, U2, U3 mesurées par le module de mesure 66 et un premier logiciel 103 d'échantillonnage, avec une période d'échantillonnage $P_{ech}$, de la valeur de la tension mesurée U1, U2, U3. Les échantillons de la tension mesurée U1, U2, U3 sont notés respectivement $U1_m$, $U2_m$, $U3_m$, où m est un indice d'échantillon variant entre 1 et Ntotal_ech, Ntotal_ech étant un nombre entier représentant le nombre d'échantillons d'une grandeur mesurée X dans la fenêtre d'échantillonnage. La grandeur mesurée X est, par exemple, la tension U1, U2, U3 mesurée par le premier dispositif 60, ou encore l'intensité I1A, ..., I3N mesurée par le deuxième dispositif 62A comme cela sera décrit par la suite.

La fenêtre d'échantillonnage est, par exemple, choisie égale à une seconde.

La période d'échantillonnage $P_{ech}$ est égale au rapport de la période de tension $P_{tension}$ et d'un nombre Nech d'échantillons de la grandeur X mesurée par période de tension $P_{tension}$. La période d'échantillonnage $P_{ech}$ vérifie l'équation :

$$P_{ech} = \frac{P_{tension}}{Nech} \qquad\qquad (1)$$

Où $P_{tension}$ est la période de la tension, égale à l'inverse de la fréquence F de la tension.

Le nombre d'échantillons par période de tension Nech est de préférence un entier. Le nombre d'échantillons par période de tension Nech est, par exemple, égal à 36.

La mémoire 100 est apte à stocker un premier logiciel 104 de détermination d'une première table de corrélation TABLE_1 et d'une deuxième table de corrélation TABLE_2, à partir d'une valeur mesurée de la fréquence F.

La première table TABLE_1 contient une pluralité de premiers coefficients $C^1_{j,m}$. De préférence, la première table TABLE_1 contient Ntotal_ech premiers coefficients $C^1_{j,m}$. Chaque premier coefficient $C^1_{j,m}$ est fonction d'un cosinus dépendant de la fréquence F de la tension.

La deuxième table TABLE_2 contient une pluralité de deuxièmes coefficients $C^2_{j,m}$. De préférence, la deuxième table TABLE_2 contient Ntotal_ech deuxièmes coefficients $C^2_{j,m}$. Chaque deuxième coefficient $C^2_{j,m}$ est fonction d'un sinus dépendant de la fréquence F de la tension.

La mémoire 100 est apte à stocker un premier logiciel 105 de calcul d'un premier ensemble d'au moins un paramètre de surveillance de la tension U1, U2, U3. Le premier ensemble comprend par exemple une pluralité de coefficients d'une transformée des échantillons $U1_m$, $U2m$, $U3_m$ de chaque tension mesurée, jusqu'à un rang J de valeur supérieure ou égale à 1, de préférence supérieure ou égale à 5, de préférence encore égale à 15. Par convention, le rang égal à 1 correspond au fondamental de la transformée.

D'après le théorème de Shannon, la valeur de J doit être inférieure ou égale à (Nech/2)-1. La valeur de J sera de préférence choisie égale à (Nech/2)-3. Dans l'exemple de réalisation décrit, Nech est égal à 36, et la valeur de J est alors égale à 15 avec la formule précitée.

La mémoire 100 est apte à stocker un premier logiciel de calcul 105 configuré pour calculer au moins un paramètre de surveillance de la tension U1, U2, U3 en fonction d'au moins une valeur mesurée de ladite tension U1, U2, U3, de préférence en fonction de certaines des valeurs mesurées de ladite tension U1, U2, U3 au cours d'une période d'émission $P_{émission}$ donnée. Les paramètres de surveillance comprennent par exemple des coefficients d'une transformée des valeurs de tension U1, U2, U3 mesurées.

La transformée est, par exemple, une transformée de Fourier, et le premier logiciel de calcul 105 est propre à calculer les coefficients réel $ReU_{i,j}$ et imaginaire $ImU_{i,j}$ de la décomposition en série de Fourier des échantillons $Ui_m$ de chaque tension mesurée Ui, où i est un indice de la phase correspondante, par exemple respectivement égal à 1, 2 et 3, j est un rang de la décomposition en série de Fourier, avec j compris entre 1 et J, J étant égal au nombre de rangs de ladite décomposition.

En variante, la transformée est une transformée de Laplace.

La mémoire 100 est apte à stocker un premier logiciel 106 d'émission d'un premier message M1 à destination de chaque deuxième dispositif 62A, ..., 62N. Les instants d'émission de deux messages principaux M1 successifs sont séparés par une période d'émission $P_{émission}$. Chaque période d'émission $P_{émission}$ présente de préférence une valeur prédéterminée, par exemple égale à une seconde. De préférence, la période d'émission $P_{émission}$ est choisie égale à la durée de la fenêtre d'échantillonnage.

Le nombre d'échantillons Ntotal_ech est donc égal au nombre d'échantillons dans la période d'émission $P_{émission}$. Le nombre d'échantillons Ntotal_ech est calculé selon l'équation :

$$Ntotal\_ech = \frac{P_{émission}}{P_{tension}} \times Nech \ , \qquad\qquad (2)$$

Chaque période d'émission $P_{émission}$ correspond à un multiple $N_{tension}$ de périodes de tension $P_{tension}$, la période de tension $P_{tension}$ étant égale à l'inverse de la fréquence F de la tension alternative U1, U2, U3. Le multiple $N_{tension}$ est de préférence un nombre entier de valeur supérieure ou égale à 2, et la période d'émission $P_{émission}$ correspond alors à un multiple entier de périodes de tension $P_{tension}$.

En variante, le multiple $N_{tension}$ est un nombre réel de valeur strictement supérieure à 1. Selon cette variante, un lissage de la valeur des échantillons de l'intensité mesurée sera alors effectué pour prendre en compte cette valeur non entière du multiple $N_{tension}$.

Le multiple $N_{tension}$ est calculé selon l'équation :

$$N_{tension} = \frac{P_{émission}}{P_{tension}} \tag{3}$$

La mémoire 100 est apte à stocker un logiciel 107 de mesure de la fréquence F de la tension. Le logiciel de mesure 107 est configuré pour calculer, pour chaque période d'émission $P_{émission}$, la fréquence F de la tension à partir d'échantillons de tension $U1_m$, $U2_m$, $U3_m$. Le logiciel de mesure 107 est apte à stocker la valeur calculée de la fréquence F dans la mémoire 100 sous forme d'une valeur stockée de la fréquence $F_{sto}$. Le logiciel de mesure 107 est configuré pour transmettre la valeur de la fréquence mesurée F au premier logiciel d'échantillonnage 103, au premier logiciel de détermination 104, au premier logiciel de calcul 105 et au premier logiciel d'émission 106.

La mémoire 100 est apte à stocker un logiciel 108 de distribution d'un unique jeton aux deuxièmes dispositifs 62A, ..., 62N de manière successive.

Lorsqu'ils sont exécutés par le processeur 98, le premier logiciel d'acquisition 102, le premier logiciel d'échantillonnage 103, le premier logiciel de détermination 104, le premier logiciel de calcul 105, le premier logiciel d'émission 106, le logiciel de mesure 107, et respectivement le logiciel de distribution du jeton distribué 108 forment un premier module d'acquisition de valeurs des tensions U1, U2, U3 mesurées, un premier module d'échantillonnage des valeurs des tensions U1, U2, U3 mesurées, un premier module de détermination d'une première table de corrélation TABLE_1 et d'une deuxième table de corrélation TABLE_2, un premier module de calcul d'un ensemble d'au moins un paramètre de surveillance de la tension, un premier module de calcul d'au moins un paramètre de surveillance de la tension, un premier module d'émission du premier message M1, un module de mesure de la fréquence et respectivement un module de distribution du jeton distribué.

En variante, le premier module d'acquisition 102, le premier module d'échantillonnage 103, le premier module de détermination 104, le premier module de calcul 105, le premier module d'émission 106, le logiciel de mesure 107, et le module de distribution du jeton distribué 108 sont réalisés sous forme de composants logiques programmables ou encore sous forme de circuits intégrés dédiés.

L'émetteur-récepteur radioélectrique 70 est conforme au protocole de communication ZigBee basé sur la norme IEEE-802.15.4. En variante, l'émetteur-récepteur radioélectrique 70 est conforme à la norme IEEE-802.15.1, ou à la norme IEEE-802.15.2, ou encore à la norme IEEE-802-11 ou encore tout autre protocole radio propriétaire.

L'antenne radioélectrique 72 est adaptée pour émettre des signaux radioélectriques à destination des antennes 82A, ..., 82N des deuxièmes dispositifs et de l'antenne 94 du dispositif de centralisation, et également pour recevoir des signaux radioélectriques desdites antennes 82A, ..., 82N, 94. Autrement dit, le premier dispositif 60 est relié à chacun des deuxièmes dispositifs 62A, ..., 62N et au dispositif de centralisation 64 par une liaison radioélectrique correspondante.

Le module d'alimentation 74 est propre à alimenter électriquement le module de mesure 66, l'unité de traitement d'informations 68 et l'émetteur-récepteur radioélectrique 70 à partir de la tension triphasée circulant à travers les conducteurs primaires 34, 36, 38.

Chaque capteur de l'intensité 76A du deuxième dispositif 62A est propre à mesurer une intensité respective parmi une première intensité I1A circulant dans le premier conducteur secondaire de départ 42A, une deuxième intensité I2A circulant dans le deuxième conducteur secondaire de départ 44A et une troisième intensité I3A circulant dans le troisième conducteur secondaire de départ 46A.

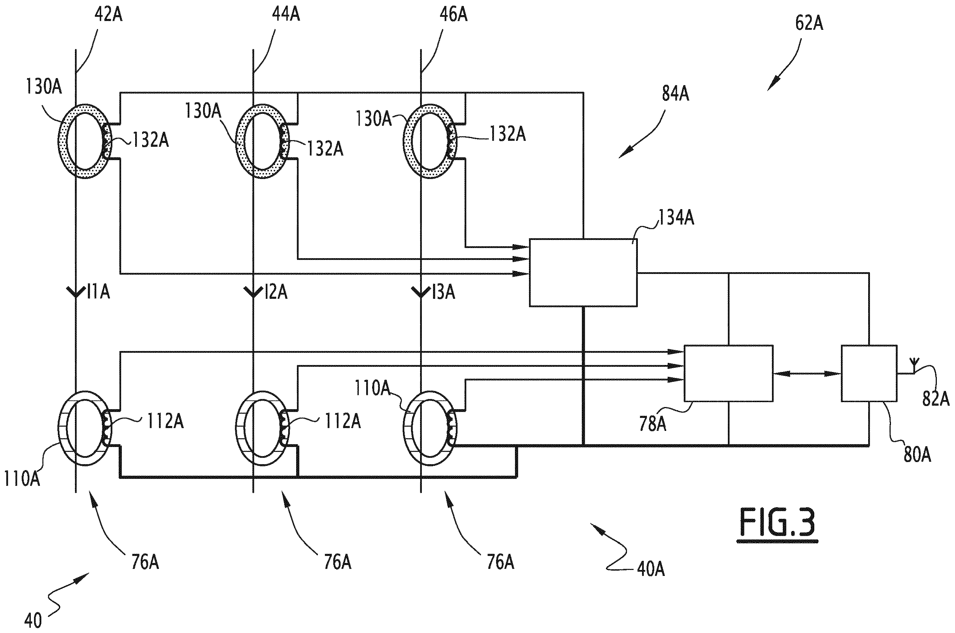

Chaque capteur de l'intensité 76A, également appelé capteur de courant, comporte un premier tore 110A disposé autour du conducteur secondaire de départ 42A, 44A, 46A correspondant et un premier enroulement 112A agencé autour du premier tore, comme représenté sur la figure 3. La circulation du courant à travers le conducteur secondaire de départ correspondant est propre à engendrer un courant induit proportionnel à l'intensité du courant dans le premier enroulement 112A. Le premier tore 110A est un tore de Rogowski. Le premier tore 110A est de préférence un tore ouvrant afin de faciliter son agencement autour des conducteurs correspondants.

L'unité de traitement d'informations 78A, visible sur la figure 2, comporte un processeur de données 114A, et une mémoire 116A associée au processeur de données. La mémoire 116A est propre à stocker un deuxième logiciel 118A d'acquisition de valeurs des intensités respectives mesurées par chaque capteur de courant 76A, et un deuxième logiciel 119A d'échantillonnage, avec une période d'échantillonnage $P_{ech}$, de la valeur des première, deuxième et troisième intensités I1A, I2A, I3A mesurées, et un logiciel 120A de réception du premier message M1.

La fenêtre d'échantillonnage est, par exemple, choisie égale à la période d'émission P$_{émission}$.

Les échantillons des première, deuxième et troisième intensités I1A, I2A, I3A mesurées sont notés respectivement I1A$_m$, I2A$_m$, I3A$_m$ où m est l'indice d'échantillon variant entre 1 et Ntotal_ech.

La mémoire 116A est apte à stocker un deuxième logiciel 121A de calcul d'un deuxième ensemble d'au moins un paramètre de surveillance de l'intensité I1A, I2A, I3A. Le deuxième ensemble comprend par exemple une pluralité de coefficients d'une transformée des échantillons I1A$_m$, I2A$_m$, I3A$_m$ jusqu'au rang J. La transformée est, par exemple, une transformée de Fourier, et le deuxième logiciel de calcul 121A est propre à calculer les coefficients réel Re$I_{iA,j}$ et imaginaire Im$I_{iA,j}$ de la décomposition en série de Fourier des échantillons IiA$_m$ de chaque intensité mesurée IiA, où i est l'indice de la phase correspondante, j est le rang de la décomposition en série de Fourier, avec j compris entre 1 et J.

En variante, la transformée est une transformée de Laplace.

La mémoire 116A est apte à stocker un logiciel 122A de synchronisation de l'échantillonnage des intensités I1A, I2A, I3A mesurées par rapport à l'échantillonnage de la tension mesurée U1, U2, U3.

Dans la suite de la description, chaque période de tension est référencée à l'aide de l'indice k. Par convention, la période de tension d'indice k égal à 1 correspond à la période temporelle au cours de laquelle le premier message M1 est émis par le premier dispositif 60 et respectivement reçu par chaque deuxième dispositif 62A, ..., 62N, et la période de tension d'indice k égal à 2 correspond à la période au début de laquelle la synchronisation des échantillonnages de tension et d'intensités est effectuée.

La mémoire 116A est apte à stocker un deuxième logiciel 123A de détermination de détermination de la première table de corrélation TABLE_1 et de la deuxième table de corrélation TABLE_2, à partir d'une valeur mesurée de la fréquence F.

La mémoire 116A est apte à stocker un deuxième logiciel 128A d'émission d'un deuxième message M2A à destination du dispositif de centralisation 64.

Lorsqu'ils sont exécutés par le processeur 114A, le deuxième logiciel d'acquisition 118A, le deuxième logiciel d'échantillonnage 119A, le logiciel de réception 120A, le deuxième logiciel de calcul 121A, le logiciel de synchronisation 122A, le deuxième logiciel de détermination 123A et respectivement le deuxième logiciel d'émission 128A forment un deuxième module d'acquisition de valeurs des intensités mesurées, un deuxième module d'échantillonnage des valeurs des intensités mesurées, un module de réception du premier message M1, un deuxième module de calcul de calcul d'au moins un paramètre de surveillance de l'intensité, un module de synchronisation de l'échantillonnage des intensités I1A, I2A, I3A mesurées par rapport à l'échantillonnage de la tension mesurée U1, U2, U3, un deuxième module de détermination, et respectivement un deuxième module d'émission du deuxième message M2A.

En variante, le deuxième module d'acquisition 118A, le deuxième module d'échantillonnage 119A, le module de réception 120A, le deuxième module de calcul 121A, le module de synchronisation 120A, le deuxième module de détermination 123A et le deuxième module d'émission 128A sont réalisés sous forme de composants logiques programmables ou encore sous forme de circuits intégrés dédiés.

L'émetteur-récepteur radioélectrique 80A est du même type que l'émetteur-récepteur radioélectrique 70.

L'antenne radioélectrique 82A, du même type que l'antenne radioélectrique 72, est adaptée pour recevoir des signaux radioélectriques de l'antenne 72 du premier dispositif et de l'antenne 94 du dispositif de centralisation et également pour émettre des signaux radioélectriques aux antennes 72, 94.

Le module d'alimentation 84A, visible sur la figure 3, est propre à alimenter l'unité de traitement d'informations 78A et l'émetteur-récepteur radioélectrique 80A. Le module d'alimentation 84A comporte, pour chacun des premier 42A, deuxième 44A et troisième 46A conducteurs secondaires, un deuxième tore 130A disposé autour du conducteur secondaire 42A, 44A, 46A correspondant et un deuxième enroulement 132A agencé autour du deuxième tore. La circulation du courant dans le conducteur secondaire 42A, 44A, 46A correspondant est propre à engendrer un courant induit dans le deuxième enroulement 132A.

Le module d'alimentation 84A comporte un convertisseur 134A connecté à chacun des deuxièmes enroulements 132A et propre à délivrer une tension prédéterminée à l'unité de traitement d'informations 78A et à l'émetteur-récepteur radioélectrique 80A. Chaque deuxième tore 130A est un tore en fer. Chaque deuxième tore 130A est de préférence un tore ouvrant afin de faciliter son agencement autour des conducteurs correspondants.

Autrement dit, le deuxième dispositif 62A est autoalimenté par l'intermédiaire du module d'alimentation 84A comportant les deuxièmes tores 130A adaptés pour récupérer l'énergie magnétique issue de la circulation du courant dans les conducteurs secondaires 42A, 44A, 46A correspondants.

Les éléments des autres deuxièmes dispositifs 62B, ..., 62N sont identiques aux éléments du premier deuxième dispositif 62A décrits précédemment, et comportent les mêmes sous-éléments en remplaçant à chaque fois la lettre A par la lettre B, ..., N correspondante concernant les références des sous-éléments.

L'unité de traitement d'informations 86 du dispositif de centralisation, visible sur la figure 2, comporte un processeur de données 136, et une mémoire 138 associée au processeur. La mémoire 138 est apte à stocker un logiciel 140 de réception des deuxièmes messages M2A,..., M2N, un logiciel 142 d'enregistrement dans la base de données 88 des informations contenues dans les messages M2A,..., M2N reçus. La mémoire 138 est propre à stocker un logiciel 144 de traitement desdites informations reçues, un logiciel 146 d'affichage de données et un logiciel 148 de transmission de données à destination d'un serveur distant, non représenté. Le logiciel de traitement 144 est notamment configuré pour calculer l'énergie électrique $E_i$ du courant alternatif circulant dans chaque conducteur électrique secondaire 42A, ..., 46N à partir des paramètres de surveillance calculés par le premier dispositif de surveillance 60 et par chaque deuxième dispositif de surveillance 62A, ..., 62N, ces paramètres de surveillance calculés étant contenus dans les messages de données M2A, ..., M2N reçus.

Lorsqu'ils sont exécutés par le processeur 136, le logiciel de réception 140, le logiciel d'enregistrement 142, le logiciel de traitement 144, le logiciel d'affichage 146, et respectivement le logiciel de transmission 148 forment un module de réception des deuxièmes messages M2A,..., M2N, un module d'enregistrement dans la base de données 88 des informations contenues dans les messages M2A,..., M2N reçus, un module de traitement desdites informations reçues, un module d'affichage de données et un module de transmission de données à destination d'un serveur distant.

En variante, le module de réception 140, le module d'enregistrement 142, le module de traitement 144, le module d'affichage 146, et le module de transmission 148 sont réalisés sous forme de composants logiques programmables ou encore sous forme de circuits intégrés dédiés.

L'interface homme-machine 90 comporte un écran d'affichage et un clavier de saisie, non représentés.

L'émetteur-récepteur radioélectrique 92 est du même type que les émetteurs-récepteurs radioélectriques 70, 80A, ..., 80N.

L'antenne radioélectrique 94, du même type que les antennes radioélectriques 72, 82A, ..., 82N, est propre à recevoir des signaux radioélectriques issus de l'antenne 72 du premier dispositif et des antennes 82A, ..., 82N des deuxièmes dispositifs et également à émettre des signaux radioélectriques à destination desdites antennes 72, 82A, ..., 82N.

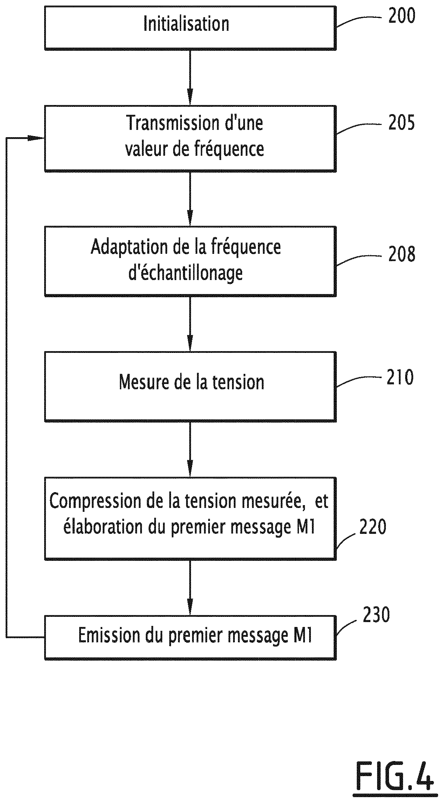

Le fonctionnement du système de surveillance 20 va désormais être expliqué à l'aide des figures 4, 5 et 6 représentant des organigrammes des étapes d'un procédé de surveillance mises en oeuvre respectivement par le premier dispositif 60, par les deuxièmes dispositifs 62A, ..., 62N et par le dispositif de centralisation 64.

Comme représenté sur la figure 4, lors d'une première étape 200, le premier dispositif 60 s'initialise, et la valeur stockée $F_{sto}$ de la fréquence F est fixée égale à la valeur nominale de la fréquence $F_{nom}$ par le logiciel de mesure 107 lors de l'étape d'initialisation 200. La valeur nominale de la fréquence $F_{nom}$ est définie comme étant l'inverse de la période nominale de tension $P_{nom}$.

La période nominale de tension $P_{nom}$ est égale à 20 ms en Europe et 16,66 ms aux Etats Unis.

Le premier logiciel d'échantillonnage 103 calcule la période d'échantillonnage $P_{ech}$ suivant l'équation (1), en considérant que la période de tension $P_{tension}$ est égale à la période nominale de la tension $P_{nom}$. La période d'échantillonnage $P_{ech}$ vérifie donc l'équation :

$$P_{ech} = \frac{P_{nom}}{N_{ech}} \qquad\qquad (4)$$

Le premier logiciel de détermination 104 détermine, en outre, la première table de corrélation TABLE_1 contenant Ntotal_ech premiers coefficients $C^1_{j,m}$, et la deuxième table TABLE_2 contenant Ntotal_ech deuxièmes coefficients $C^2_{j,m}$.

Chaque premier coefficient $C^1_{j,m}$ est fonction d'un cosinus dépendant de la fréquence F de la tension. Chaque deuxième coefficient $C^2_{j,m}$ est fonction d'un sinus dépendant de la fréquence F de la tension.

Chaque premier coefficient $C^1_{j,m}$ vérifie, par exemple, l'équation :

$$C^1_{j,m} = \cos(2 \times \Pi \times F \times j \times m \times P_{ech}), \qquad\qquad (5)$$

et

chaque deuxième coefficient $C^2_{j,m}$ vérifie, par exemple, l'équation :

$$C^2_{j,m} = \sin(2 \times \Pi \times F \times j \times m \times P_{ech}) \qquad\qquad (6)$$

où j est compris entre 1 et J, J étant un entier de préférence supérieur ou égal à 5, de préférence égal à 17,

F est la valeur de fréquence de la tension mesurée lors de l'avant-dernière période d'émission $P_{émission}$ ; si aucune valeur F de la fréquence n'a encore été mesurée, la valeur F de la fréquence est prise égale à l'inverse de la période nominale du courant ; cela s'écrit mathématiquement : $F=1/P_{nom}$, et

m est l'indice d'échantillon variant entre 1 et Ntotal_ech.

Le logiciel de mesure 107 transmet au premier logiciel d'échantillonnage 103, au premier logiciel de détermination 104, au premier logiciel de calcul 105, et au premier logiciel d'émission 106, lors de l'étape suivante 205, la valeur stockée $F_{sto}$ dans le logiciel de mesure 107.

Lorsque l'étape 205 est précédée immédiatement de l'étape d'initialisation 200, la valeur stockée $F_{sto}$ est égale à la valeur nominale de la fréquence $F_{nom}$.

Lorsque l'étape 205 est précédée de l'étape 230 correspondant à une période d'émission $P_{émission}$ précédente, la valeur stockée $F_{sto}$ est égale à la valeur de la fréquence F mesurée lors de l'avant-dernière période d'émission $P_{émission}$.

Lors de l'étape suivante 208, la période d'échantillonnage $P_{ech}$ est recalculée par le premier logiciel d'échantillonnage 103 en fonction de la valeur de la fréquence F de la tension triphasée transmise par le logiciel de mesure 107. Autrement dit, la période d'échantillonnage $P_{ech}$ est calculée à partir de la valeur de la fréquence F, sachant que le produit de la période d'échantillonnage $P_{ech}$ et de la fréquence F est égal à une constante prédéterminée.

Il n'est pas nécessaire de recalculer la première table TABLE_1 et la deuxième table TABLE_2 car le produit de la fréquence F et de la période d'échantillonnage $P_{ech}$ est inchangé, la période d'échantillonnage $P_{ech}$ ayant été recalculée en considérant que le produit de la fréquence F et de la période d'échantillonnage $P_{ech}$ est constant.

La période de tension $P_{tension}$ correspond à un multiple de la période d'échantillonnage $P_{ech}$, conformément à l'équation (2) ci-dessus.

Le premier dispositif 60 mesure ensuite, lors de l'étape 210, les première, deuxième et troisième tensions U1, U2, U3 à l'aide de son module de mesure 66 et de son premier logiciel d'acquisition 102. Le premier dispositif 60 mesure les première, deuxième et troisième tensions U1, U2, U3 pendant une durée égale à la période d'émission $P_{émission}$. Le premier logiciel d'échantillonnage 103 échantillonne alors les valeurs mesurées des tensions U1, U2, U3 suivant la période d'échantillonnage $P_{ech}$, calculée lors de l'étape 208.

La valeur F de la fréquence de tension est mesurée régulièrement lors de la période d'émission $P_{émission}$, et la valeur stockée de la fréquence $F_{sto}$ est mise à jour. Cela signifie que la valeur stockée de la fréquence $F_{sto}$ est fixée égale à la valeur F de la fréquence mesurée.

Le logiciel de mesure 107 calcule, pour chaque échantillon Ui,m, les parties réelle RePi,m et imaginaire ImPi,m d'un phaseur de tension Pi,m correspondant selon les équations :

$$\operatorname{Re} P_{i,m} = \frac{\sqrt{2}}{Nech} \sum_{n=0}^{Nech-1} U_{i,m+n} \cos\left(\frac{2\Pi n}{Nech}\right) \qquad (7)$$

$$\operatorname{Im} P_{i,m} = \frac{-\sqrt{2}}{Nech} \sum_{n=0}^{Nech-1} U_{i,m+n} \sin\left(\frac{2\Pi n}{Nech}\right) \qquad (8)$$

Le calcul des parties réelle $RePi,m$ et imaginaire $ImP_{i,m}$ du phaseur de tension $P_{i,m}$ sont donc calculées, pour chaque échantillon de tension $U_{i,m}$, à partir des échantillons de tension $U_{i,m}$ acquis lors de la dernière période de tension.

Le logiciel de mesure 107 mesure ensuite, avec une période de mesure $P_{mesure}$, la différence angulaire $\Delta\varphi$ entre deux phaseurs de tension $P_{i,m1}$ et $P_{i,m2}$ correspondant à deux instants temporels séparés d'une période de mesure $P_{mesure}$, par l'équation :

$$\tan(\Delta\varphi) = \frac{\operatorname{Im} P_{i,m2} \times \operatorname{Re} P_{i,m1} - \operatorname{Re} P_{i,m2} \times \operatorname{Im} P_{i,m1}}{\operatorname{Im} P_{i,m2} \times \operatorname{Im} P_{i,m1} + \operatorname{Re} P_{i,m2} \times \operatorname{Re} P_{i,m1}} \qquad (9)$$

La période de mesure $P_{mesure}$ est, par exemple, sensiblement égale à la moitié de la période de tension $P_{tension}$.

La valeur F de la fréquence est alors calculée suivant l'équation :

$$F = F_{sto} \times (1 + \frac{\Delta\varphi}{\Pi}) \qquad (10)$$

La valeur F de la fréquence est donc calculée à chaque période de mesure $P_{mesure}$.

Chaque période de mesure $P_{mesure}$ sera par la suite référencée par un indice z.

Après chaque période de mesure $P_{mes}^{z}$, le logiciel de mesure 107 compare le signe de la différence angulaire $\Delta\varphi$ calculée lors de la période de mesure d'indice z aux signes des différences angulaires $\Delta\varphi$ calculées lors des périodes de mesure précédentes. De préférence, le logiciel de mesure 107 compare le signe de la différence angulaire $\Delta\varphi$ calculée lors de la période de mesure d'indice z aux signes des différences angulaires $\Delta\varphi$ calculées lors des 9 périodes de mesure précédentes.

Si le signe de la différence angulaire $\Delta\varphi$ est resté constant lors des 10 périodes de mesure $P_{mes}^{z-9}$ à $P_{mes}^{z}$, la valeur de la fréquence stockée $F_{sto}$ est fixée égale à la valeur de la fréquence F mesurée lors de la période de mesure d'indice z. Sinon, la valeur de la fréquence stockée $F_{sto}$ reste inchangée.

Si la valeur absolue de la différence entre la valeur de la fréquence stockée $F_{sto}$ et la valeur de la fréquence F mesurée est supérieure à une valeur prédéfinie Vp, par exemple 5 Hertz (Hz), et la valeur de la fréquence stockée $F_{sto}$ est supérieure à la valeur de la fréquence F mesurée, la valeur de la fréquence stockée $F_{sto}$ est diminuée de la valeur prédéfinie Vp. Cela s'écrit mathématiquement $F_{sto} := F_{sto} -Vp$.

Si la valeur absolue de la différence entre la valeur de la fréquence stockée $F_{sto}$ et la valeur de la fréquence F mesurée est supérieure à une valeur prédéfinie Vp, par exemple 5 Hertz (Hz), et la valeur de la fréquence stockée $F_{sto}$ est inférieure à la valeur de la fréquence F mesurée, la valeur de la fréquence stockée $F_{sto}$ est augmentée de la valeur prédéfinie Vp. Cela s'écrit mathématiquement $F_{sto} := F_{sto} +Vp$.

La valeur de la fréquence stockée $F_{sto}$ est bornée. Cela signifie que, si la valeur de la fréquence F mesurée est inférieure à une borne inférieure prédéfinie Bi, la fréquence stockée $F_{sto}$ est fixée égale à la valeur de la borne inférieure Bi. Cela s'écrit mathématiquement $F_{sto} := Bi$. Par exemple, la borne inférieure Bi est égale à 40 Hz.

Si la valeur de la F mesurée est supérieure à une borne supérieure prédéfinie Bs, la fréquence stockée $F_{sto}$ est fixée égale à la valeur de la borne supérieure Bs. Cela s'écrit mathématiquement $F_{sto} := Bs$. Par exemple, la borne supérieure Bs est égale à 70 Hz.

La valeur stockée $F_{sto}$ est transmise au premier logiciel d'échantillonnage 103, au premier logiciel de détermination 104, au premier logiciel de calcul 105, et au premier logiciel d'émission 106, lors de l'étape 205.

Lors de l'étape 220, le premier dispositif 60 calcule un ensemble de paramètres de surveillance des tensions U1, U2, U3. Les paramètres de surveillance de la tension comprennent des coefficients d'une transformée des tensions mesurées U1, U2, U3.

Le premier dispositif 60 compresse donc les valeurs mesurées des tensions U1, U2, U3 en déterminant des coefficients réel $ReU_{i,j}$ et imaginaire $ImU_{i,j}$ de la décomposition en série de Fourier des échantillons $Ui_m$ de chaque tension mesurée U1, U2, U3 à l'aide de son premier logiciel de calcul 105. Ceci permet de limiter la quantité de données transmises par l'intermédiaire des liaisons radioélectriques entre le premier dispositif 60 et le dispositif de centralisation 64.

Les coefficients $ReU_{i,j}$, $ImU_{i,j}$ de la décomposition en série de Fourier sont, par exemple, obtenus par une corrélation entre les échantillons des valeurs mesurées et les coefficients $C^{1}_{j,m}$, $C^{2}_{j,m}$ contenus dans la première table TABLE_1 et respectivement la deuxième table TABLE_2. Les coefficients $ReU_{i,j}$, $ImU_{i,j}$ de la décomposition en série de Fourier sont donc calculés en une seule fois pour toute la période d'émission $P_{émission}$. Les coefficients $ReU_{i,j}$, $ImU_{i,j}$ de la décomposition en série de Fourier sont calculés par des produit de vecteurs entre les tables TABLE_1, TABLE_2 et un vecteur contenant les échantillons de tension. Le calcul des coefficients $ReU_{i,j}$, $ImU_{i,j}$ de la décomposition en série de Fourier est donc simplifié.

Plus précisément, le coefficient réel du fondamental, noté $ReU_{i,1}$, est une corrélation, sur une durée égale à la période d'émission $P_{émission}$, entre les échantillons $Ui_m$ du signal de tension Ui et un cosinus de fréquence égale à la fréquence F de la tension triphasée, où Ui représente la tension de la phase, i étant égal à 1, 2 ou 3. Le coefficient imaginaire du fondamental, noté $ImU_{i,1}$, est une corrélation, sur une durée égale à la période d'émission $P_{émission}$, entre les échantillons $U_{,m}$ du signal de tension Ui et un sinus de fréquence égal à la fréquence F.

Le coefficient réel de l'harmonique de rang j, noté $ReU_{i,j}$, j étant compris entre 2 et J, est la corrélation, sur une durée égale à la période d'émission $P_{émission}$, entre les échantillons $Ui_m$ du signal de tension Ui et un cosinus de fréquence égal à j fois la fréquence F. Le coefficient imaginaire de l'harmonique de rang j, noté $ImU_{i,j}$, est la corrélation, sur une durée égale à la période d'émission $P_{émission}$, entre les échantillons $Ui_m$ du signal de tension Ui et un sinus de fréquence égal à j fois la fréquence F.

Autrement dit, les coefficients $ReU_{i,j}$ et $ImU_{i,j}$ vérifient les équations suivantes, j étant compris entre 1 et J :

$$ReU_{i,j} = \sum_{m=1}^{Ntotal\_ech} Ui_m \times C_{j,m}^1 \qquad (11)$$

$$ImU_{i,j} = \sum_{m=1}^{Ntotal\_ech} Ui_m \times C_{j,m}^2 \qquad (12)$$

En variante, les coefficients $ReU_{i,j}$ et $ImU_{i,j}$ sont obtenus par une transformée de Fourier rapide, également appelée FFT (de l'anglais *Fast Fourier Transform*).

Le premier logiciel de calcul 105 calcule ainsi les coefficients complexes $ReU_{i,j}$ et $ImU_{i,j}$ des décompositions en série de Fourier des trois tensions U1, U2, U3 pour le fondamental et les harmoniques 2 à J.

Enfin, lors de l'étape 230, le premier dispositif 60 émet, à l'aide de son logiciel d'émission 106, le premier message M1 à destination de chacun des deuxièmes dispositifs 62A, ..., 62N. Le premier message M1 contient les coefficients complexes $ReU_{i,j}$ et $ImU_{i,j}$ des décompositions en série de Fourier des trois tensions U1, U2, U3 calculés lors de l'étape 220 pour l'ensemble de la période d'émission P$_{émission}$.

Le premier dispositif 60 lance en outre, lors de cette étape 230, une première temporisation égale à une durée de référence Df, à compter de l'instant de début d'émission du premier message M1, également appelé top d'émission Te du premier message M1. Lorsque cette première temporisation sera écoulée, le premier dispositif 60 débutera alors l'échantillonnage des valeurs mesurées des trois tensions U1, U2, U3, c'est-à-dire à un instant de début d'échantillonnage Tm égal à l'instant de début d'émission Te plus la durée de référence Df. L'échantillonnage, par le deuxième dispositif 62A, des valeurs mesurées des trois intensités I1A, I2A, I3A commencera également à cet instant de début d'échantillonnage Tm, comme cela sera décrit plus en détail par la suite en regard de l'étape de synchronisation 320.

La durée de référence Df a une valeur prédéterminée, par exemple sensiblement égale à 6 ms. La valeur de la durée de référence Df est connue à la fois du premier dispositif 60 et du deuxième dispositif 62A, et est choisie supérieure à la durée nécessaire à l'émission et à la réception du premier message M1. Dans l'exemple de réalisation décrit, la valeur de la durée de référence Df est stockée, préalablement à l'étape initiale 200, dans la mémoire 100 du premier dispositif et dans la mémoire 116A du deuxième dispositif 62A.

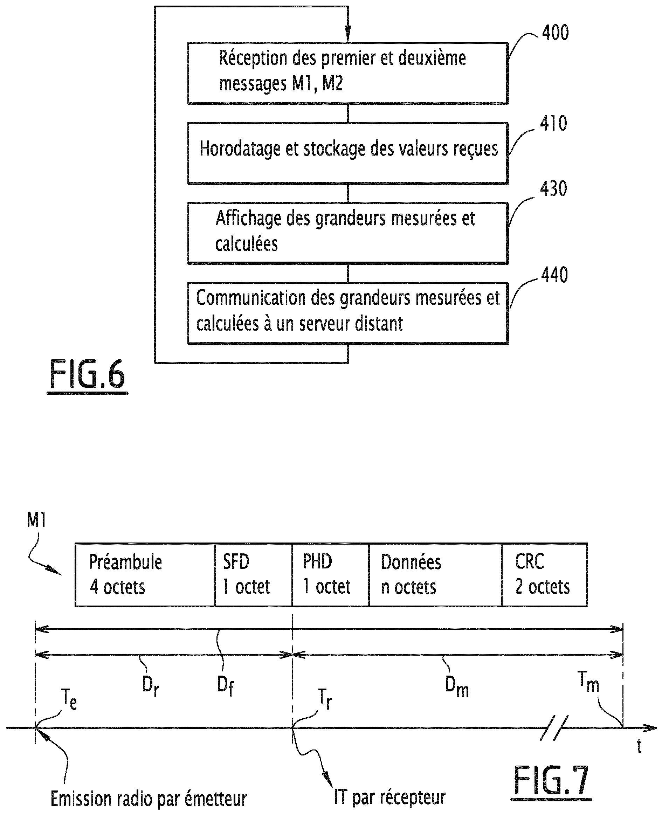

Le premier message M1 comprend un champ d'en-tête, également appelé préambule, un champ SFD (de l'anglais Start of Frame Délimiter), un champ PHR (de l'anglais Physical Header), un champ de données et un champ CRC (de l'anglais Cyclic Redundancy Check). Le préambule présente une taille de 4 octets, les champs SFD et PHR présentent chacun une taille d'un octet, le champ de données est de taille variable, notée n octets, et le champ CRC a une taille de 2 octets. Dans l'exemple de réalisation de la figure 7, le premier message M1 est constitué du champ d'entête, du champ SFD, du champ PHR, du champ de données et du champ CRC.

Le champ de données du premier message M1 contient la valeur de la fréquence F transmise lors de l'étape 205, l'identifiant du deuxième dispositif qui sera autorisé à émettre son deuxième message à destination du dispositif de centralisation 64 après la réception du premier message M1, ainsi que la valeur de la durée de référence Df en cas de modification de cette dernière. L'identifiant du deuxième dispositif autorisé à émettre ses informations de mesure est déterminé à l'aide du logiciel de distribution du jeton unique 108, l'identifiant du deuxième dispositif contenu dans le premier message M1 permettant de désigner le deuxième dispositif à qui l'unique jeton a été attribué.

Lorsque le message M1 est envoyé, les étapes 205 à 230 sont réitérées dans cet ordre. Le module de mesure 107 transmet donc une nouvelle valeur de la fréquence F au premier module de calcul 105.

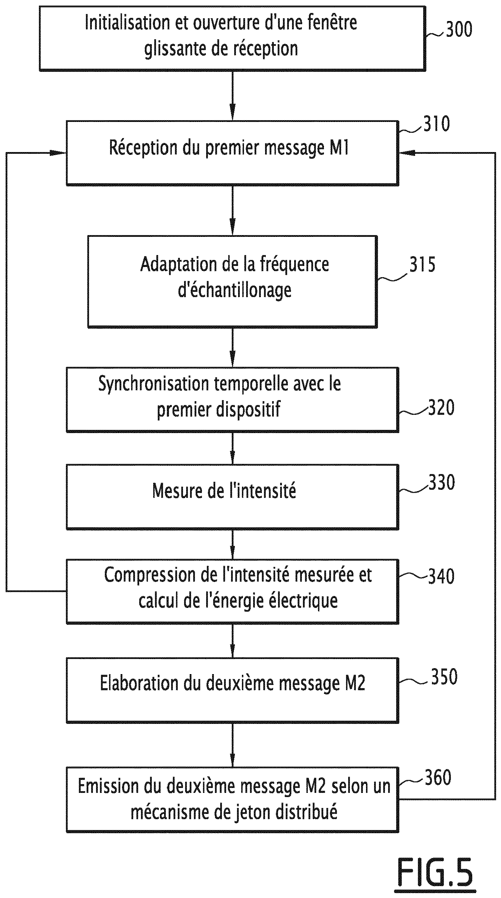

Les étapes, visibles sur la figure 5, du procédé de surveillance mises en oeuvre par les deuxièmes dispositifs 62A, ..., 62N vont être à présent décrites pour le deuxième dispositif avec la référence 62A.

Lors de l'étape 300, le deuxième dispositif 62A s'initialise et ouvre une fenêtre glissante de réception du premier message M1 à l'aide de son logiciel de réception 120A. La fenêtre de réception est une fenêtre présentant une durée de quelques dizaines de millisecondes que le deuxième dispositif 62A fait glisser dans le temps.

Le deuxième logiciel de détermination 123A calcule, en outre, la première table de corrélation TABLE_1 et la deuxième table de corrélation TABLE_2 selon les équations (5) et (6).

Lors de la réception du premier message M1 au cours de l'étape 310, le deuxième dispositif 62A détecte l'instant Tr de réception du champ SFD, la réception du champ SFD entrainant le déclenchement d'une interruption par le récepteur radioélectrique du deuxième dispositif 62A, comme représenté sur la figure 7.

Lors de l'étape suivante 315, la période d'échantillonnage P$_{ech}$ est calculée par le deuxième logiciel d'échantillonnage 119A en fonction de la valeur de la fréquence F contenue dans le dernier message M1 reçu. Cette étape est analogue à l'étape 208 décrite précédemment, la période d'échantillonnage P$_{ech}$ vérifiant l'équation (1).

La période de tension P$_{tension}$ est ainsi recalculée, par le deuxième logiciel d'échantillonnage 119A, à chaque réception de premier message M1 à l'aide de la valeur de la fréquence de tension F contenue dans le premier message M1.

Le deuxième dispositif 62A passe ensuite à l'étape 320 de synchronisation temporelle avec le premier dispositif 60. La détection de l'instant de réception Tr permet de calculer, à l'aide du logiciel de synchronisation 122A, l'instant Tm de début de l'échantillonnage des valeurs mesurées des trois intensités I1A, I2A, I3A. L'instant de début de l'échantillonnage Tm est en effet égal à l'instant de réception Tr plus une durée de synchronisation Dm, la durée de synchronisation Dm étant égale à la durée de référence Df moins une durée de transmission radio Dr, comme représenté sur la figure 7. La durée de transmission radio Dr est une valeur dépendant de l'émetteur-récepteur radioélectrique 70 et de l'émetteur-récepteur radioélectrique 80A. La durée de transmission radio Dr correspond à la période temporelle entre l'instant de début d'émission Te et l'instant de réception Tr.

La durée de transmission radio Dr est par exemple sensiblement égale à 0,6 ms, et est connue du deuxième dispositif 62A. Dans l'exemple de réalisation décrit, la valeur de la durée de transmission radio Dr est stockée, préalablement à l'étape 300, dans la mémoire 116A du deuxième dispositif 62A.

Le deuxième dispositif 62A lance alors, à partir de l'instant de réception Tr et à l'aide du logiciel de synchronisation 122A, une deuxième temporisation égale à la durée de synchronisation Dm, la valeur de la durée de synchronisation Dm étant calculée par soustraction de la valeur de la durée de transmission radio Dr à la valeur de la durée de référence Df, la valeur de la durée de transmission radio Dr et la valeur de la durée de référence Df étant stockées dans la mémoire 116A comme décrit précédemment.

Le premier dispositif 60 avait par ailleurs lancé, lors de l'étape 230, la première temporisation égale à la durée de référence Df, de sorte que le premier dispositif 60 et le deuxième dispositif 62A commenceront simultanément l'échantillonnage des valeurs de tension mesurées, et respectivement des valeurs d'intensité mesurées, lorsque les première et deuxième temporisations lancées aux étapes 230 et 320 seront écoulées, c'est-à-dire à l'instant de début d'échantillonnage Tm.

Par convention, la période de tension correspondant à l'émission du premier message M1 est la période d'indice k égal à 1. Lorsque le premier message M1 a également été reçu au cours de la période de tension d'indice k égal à 1, l'instant de début d'échantillonnage suite à la synchronisation correspond alors au début de la période de tension d'indice k égal à 2.

Lors de l'étape 320, le logiciel de synchronisation 122A initialise, à la date de réception du premier message M1, un compteur destiné à s'incrémenter jusqu'à une valeur correspondant à la période d'émission du premier message $P_{émission}$. Le deuxième dispositif 62A retourne alors automatiquement à l'étape de réception 310 environ une milliseconde avant la réception attendue du prochain premier message M1.

Si le premier message M1 n'est pas détecté par le deuxième dispositif 62A, la fenêtre de réception est refermée et aucune synchronisation n'est effectuée. Le compteur est alors incrémenté pour une nouvelle tentative de synchronisation sur le message M1 probable suivant.

Le deuxième dispositif 62A mesure alors, lors de l'étape 330 et par l'intermédiaire de ses capteurs de courant 76A et de son deuxième logiciel d'acquisition 118A, chacune des première, deuxième et troisième intensités I1A, I2A, I3A.

Le deuxième logiciel d'échantillonnage 119A échantillonne ensuite les valeurs mesurées des trois intensités I1A, I2A, I3A, l'instant de début de l'échantillonnage Tm ayant été calculé lors de l'étape 320 précédente afin d'assurer la synchronisation temporelle du capteur de l'intensité 76A par rapport à l'organe de mesure de la tension 66.

Le deuxième dispositif 62A calcule ensuite, lors de l'étape 340, un ensemble de paramètres de surveillance de chaque intensité mesurée I1A, I2A, I3A. Les paramètres de surveillance de chaque intensité mesurée I1A, I2A, I3A comprennent des coefficients d'une transformée des intensités mesurées I1A, I2A, I3A.

Le deuxième logiciel de calcul 121A compresse donc les valeurs mesurées des intensités I1A, I2A, I3A en calculant, par exemple, les coefficients réel $ReI_{iA,j}$, et imaginaire

$ImI_{iA,j}$ de la décomposition en série de Fourier des échantillons $IiA_m$ de chaque intensité mesuré I1A, I2A, I3A des trois phases de manière analogue au calcul, décrit pour l'étape 220, des coefficients complexes $ReU_{i,j}$, $ImU_{i,j}$ de la décomposition en série de Fourier des tensions. Les coefficients réel $ReI_{iA,j}$, et imaginaire $ImI_{iA,j}$ sont donc calculés en une seule fois pour la totalité de la période d'émission $P_{émission}$.

Les coefficients $ReI_{iA,j}$, $ImI_{iA,j}$ de la décomposition en série de Fourier sont, par exemple, obtenus par une corrélation entre les échantillons des valeurs mesurées et les coefficients $C^1_{j,m}$, $C^2_{j,m}$ contenus dans la première table TABLE_1 et respectivement la deuxième table TABLE_2. Les coefficients $ReI_{iA,j}$, $ImI_{iA,j}$ de la décomposition en série de Fourier sont donc calculés en une seule fois pour toute la période d'émission $P_{émission}$. Les coefficients $ReI_{iA,j}$, $ImI_{iA,j}$ de la décomposition en série de Fourier sont calculés par des produit de vecteurs entre les tables TABLE_1, TABLE_2 et un vecteur contenant les échantillons d'intensité. Le calcul des coefficients $ReI_{iA,j}$, $ImI_{iA,j}$ de la décomposition en série de Fourier est donc simplifié.

Le coefficient réel du fondamental, également noté $ReI_{iA,1}$, est ainsi une corrélation, sur une durée égale à la période d'émission $P_{émission}$, entre les échantillons du signal de l'intensité IiA et un cosinus de fréquence égal à la fréquence F de la tension triphasée, où IiA représente l'intensité de la phase numéro i, i étant égal à 1, 2 ou 3. Le coefficient imaginaire du fondamental, également noté $ImI_{iA,1}$, est une corrélation, sur une durée égale à la période d'émission $P_{émission}$, entre les échantillons du signal de l'intensité IiA et un sinus de fréquence égal à la fréquence F.

Le coefficient réel de l'harmonique de rang j, noté $ReI_{iA,j}$, j étant compris entre 2 et J, est la corrélation, sur une durée égale à la période d'émission P$_{émission}$, entre les échantillons du signal de l'intensité IiA et un cosinus de fréquence égal à j fois la fréquence F. Le coefficient imaginaire de l'harmonique de rang j, noté Im$I_{iA,j}$, j étant compris entre 2 et J, est la corrélation, sur une durée égale à la période d'émission P$_{émission}$, entre les échantillons du signal de l'intensité IiA et un sinus de fréquence égal à j fois la fréquence F.

Les coefficients Re$I_{iA,j}$, et Im$I_{iA,j}$ vérifient alors les équations suivantes :

$$\text{Re}I_{iA,j} = \sum_{m=1}^{Ntotal\_ech} IiA_m \times C_{j,m}^1 \tag{13}$$

$$\text{Im}I_{iA,j} = \sum_{m=1}^{Ntotal\_ech} IiA_m \times C_{j,m}^2 \tag{14}$$

Le deuxième logiciel de calcul 121A calcule ensuite la puissance active P$_{i,j,A}$ associée à chaque rang j de la décomposition en série de Fourier grâce à l'équation :

$$P_{i,j,A} = \frac{(\text{Re}\,U_{i,j} \times \text{Re}\,I_{iA,j} + \text{Im}\,U_{i,j} \times \text{Im}\,I_{iA,j})}{2} \tag{15}$$

Le deuxième logiciel de calcul 121A calcule également l'énergie active E$_{i,j,A}$ associée à chaque rang j de la décomposition en série de Fourier grâce à l'équation suivant l'équation :

$$E_{i,j,A} = P_{émission} \times P_{i,j,A} \tag{16}$$

Le deuxième logiciel de calcul 121A calcule ensuite l'énergie active Ei,A de chacune des trois phases à partir des coefficients de Fourier de la tension et de l'intensité suivant l'équation :

$$E_{i,A} = \sum_{j=1}^{J} E_{i,j,A} \tag{17}$$

Le deuxième dispositif 62A élabore alors, lors de l'étape 350, son deuxième message M2A. Le deuxième message M2A contient les valeurs de l'énergie active E$_{i,A}$ de chaque phase calculées au cours de l'étape 340.

Dans l'hypothèse où l'identifiant du deuxième dispositif 62A était contenu dans le premier message M1 reçu précédemment, le deuxième dispositif 62A émet alors lors de l'étape 360 son deuxième message M2A à l'aide de son logiciel d'émission 128A. Dans le cas contraire, le deuxième dispositif 62A retourne directement à l'étape 310 de réception du premier message M1, et émettra son deuxième message M2A lorsque le premier message M1 contiendra son identifiant indiquant alors que l'unique jeton lui aura été attribué afin de l'autoriser à émettre son deuxième message M2A.

Après l'étape d'émission 360 dans le cas où le jeton avait été attribué au deuxième dispositif 62A, ou bien après l'étape 340 autrement, le deuxième dispositif 62A retourne à l'étape de réception 310 si le compteur a atteint la valeur correspondant à la période d'émission P$_{émission}$, ou bien à l'étape de mesure 330 autrement.

Les étapes du procédé de surveillance mises en oeuvre par les autres deuxièmes dispositifs 62B, ..., 62N sont identiques aux étapes 300 à 360 décrites précédemment pour le deuxième dispositif avec la référence 62A, et sont réalisées en outre de manière simultanée entre tous les deuxièmes dispositifs 62A, ..., 62N de par la synchronisation temporelle effectuée à l'aide du premier message M1.

Lors de l'étape d'émission 360, le seul deuxième dispositif parmi l'ensemble des deuxièmes dispositifs 62A, ..., 62N autorisé à émettre son deuxième message est le deuxième dispositif dont l'identifiant est contenu dans le premier message M1 reçu lors de l'étape de réception 310 précédente. Le logiciel de distribution 108 détermine selon un ordre croissant les identifiants contenus dans le premier message M1 afin d'attribuer successivement l'unique jeton aux deuxièmes dispositifs 62A, ..., 62N. Autrement dit, chaque deuxième dispositif 62A, ..., 62N émet toutes les N secondes son deuxième message M2A, ..., M2N respectif.

Comme représenté sur la figure 6, lors de l'étape 400, le dispositif de centralisation 64 reçoit, à l'aide de son logiciel de réception 140, le deuxième message du deuxième dispositif autorisé à émettre selon le mécanisme de jeton distribué, par exemple le message M2A.

Lors de l'étape 410, le dispositif de centralisation 64 enregistre ensuite dans sa base de données 88 les valeurs reçues et contenues dans le deuxième message M2A, par l'intermédiaire de son logiciel d'enregistrement 142. En complément, le logiciel de traitement 144 effectue un horodatage des données enregistrées.

Lors de l'étape 410, le dispositif de centralisation 64 enregistre ensuite dans sa base de données 88 les valeurs reçues et contenues dans le premier message M1 et dans le deuxième message M2A, par l'intermédiaire de son logiciel d'enregistrement 142. En complément, le logiciel de traitement 144 effectue un horodatage des données enregistrées.

Les grandeurs mesurées et calculées par le système de surveillance sont ensuite affichées sur l'écran de l'interface homme-machine 90 du dispositif de centralisation par l'intermédiaire du logiciel d'affichage 146 lors de l'étape 430. Ces grandeurs sont affichées sous forme de valeurs numériques et/ou sous forme de courbes.

Le dispositif de centralisation 64 transmet enfin, lors de l'étape 440 et à l'aide de son logiciel de transmission 148, ces grandeurs mesurées et calculées au serveur distant, non représenté. Le serveur distant est propre à effectuer une gestion centralisée des grandeurs mesurées et calculées pour chaque système de surveillance 20.

A l'issue de l'étape 440, le dispositif de centralisation 64 retourne à l'étape 400, afin de recevoir le deuxième message du deuxième dispositif autorisé à émettre la prochaine fois selon le mécanisme de jeton distribué, par exemple le message M2A.

Le système de surveillance 20 selon l'invention permet ainsi de calculer les énergies actives $E_1$, $E_2$, $E_3$ directement sur la période d'émission $P_{émission}$ donnée et en fonction des valeurs de la tension pour toute la période d'émission, et non seulement des valeurs de la tension mesurée pour une seule période de tension sélectionnée.

Le système de surveillance 20 selon l'invention est ainsi plus précis que le système de surveillance de l'état de la technique.

Le système de surveillance 20 est en outre adapté à la mesure d'énergie électrique même dans le cas où la fréquence F de la tension n'est pas constante.

Le système de surveillance 20 selon l'invention permet en outre d'obtenir une mesure très précise des énergies active $E_i$ pour les trois phases du courant triphasé, de par la synchronisation temporelle de chaque capteur de courant 76A par rapport au module de mesure de la tension 66.

La synchronisation temporelle est très précise, le décalage de synchronisation mesuré étant de l'ordre de plus ou moins 400 nanosecondes avec la technologie actuelle des émetteurs-récepteurs radioélectriques 70, 80A, ..., 80N, 92 et des unités de traitement d'information 68, 78A, ..., 78N, 86.

L'ensemble des dispositifs 60, 62A, ..., 62N, 64 sont reliés entre eux par des liaisons radioélectriques par l'intermédiaire de leur émetteur-récepteur radioélectrique 70, 82A, ..., 82N, 92 respectif, ce qui permet de faciliter l'installation du système de surveillance 20 dans le poste de transformation 10.

Selon un deuxième mode de réalisation, la période d'échantillonnage $P_{ech}$ est constante. La période d'échantillonnage $P_{ech}$ est alors calculée grâce à l'équation :

$$P_{ech} = \frac{P_{nom}}{N_{ech}} \qquad\qquad (18)$$

La première table de corrélation TABLE_1 et la deuxième table de corrélation TABLE_2 ne sont pas calculées lors de l'étape 200 mais lors de l'étape 208. La première table de corrélation TABLE_1 et la deuxième table de corrélation TABLE_2 sont alors recalculées lors de chaque période d'émission $P_{émission}$ en utilisant la dernière valeur de la fréquence F transmise par le logiciel de mesure 107.

Lors de l'étape suivante 315, le deuxième logiciel de détermination 123A calcule, en outre, la première table de corrélation TABLE_1 et la deuxième table de corrélation TABLE_2 selon les équations (2) et (3). Cette étape est analogue à l'étape 208 décrite précédemment.

Les autres étapes du fonctionnement de ce deuxième mode de réalisation sont identiques à celles du premier mode de réalisation.

Les avantages de ce deuxième mode de réalisation sont similaires à ceux du premier mode de réalisation. Le système de surveillance 20 permet, de plus, d'utiliser des premier et deuxième modules d'échantillonnage 103, 119A dont la période d'échantillonnage est fixe.

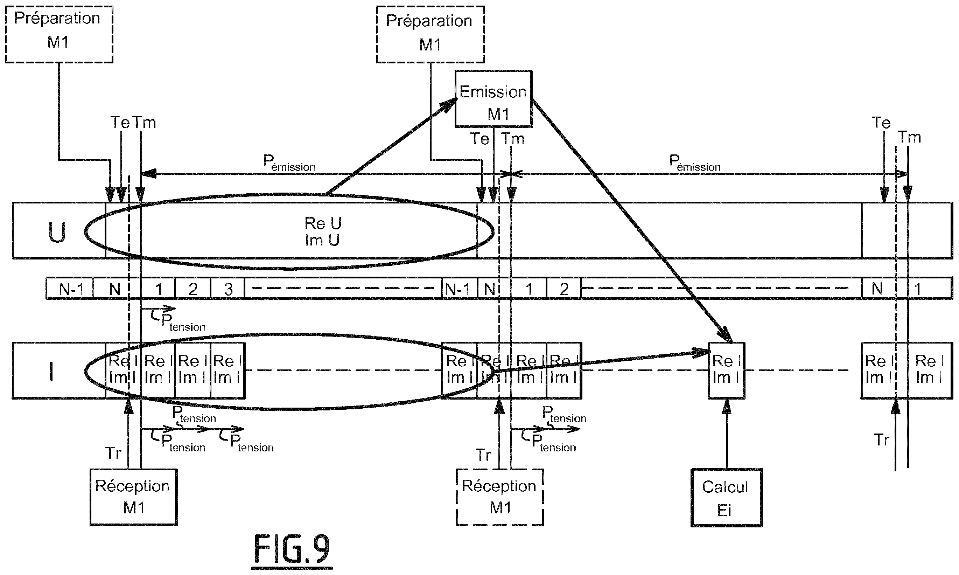

Selon un troisième mode de réalisation, décrit sur la figure 9, lors de l'étape 300, les coefficients réel $Re_{I_{iA,j}}$, et imaginaire $Im_{I_{iA,j}}$ de la décomposition en série de Fourier des échantillons $IiA_m$ de chaque intensité mesurée I1A, I2A, I3A des trois phases sont calculés pour chaque période de tension $P_{tension}$.

Le deuxième logiciel de détermination 123A détermine donc une troisième table de corrélation TABLE_3 contenant une pluralité de premiers coefficients $C1_{j,m}$ et une quatrième table de corrélation TABLE_4 contenant une pluralité de deuxièmes coefficients $C2_{j,m}$. Chacune de la troisième table TABLE_3 et de la quatrième table TABLE_4 contient alors Nech coefficients $C1_{j,m}$, $C2_{j,m}$.

Chaque premier coefficient $C1_{j,m}$ vérifie l'équation (5) précédente, et chaque deuxième coefficient $C2_{j,m}$ vérifie l'équation (6) précédente, m variant entre 1 et Nech.

Lors de l'étape 330, les échantillons des première, deuxième et troisième intensités I1A, I2A, I3A mesurées sont notés respectivement $I1A_{m,k}$, $I2A_{m,k}$, $I3A_{m,k}$ où k est l'indice de la période de tension $P_{tension}$ et m est l'indice d'échantillon variant entre 1 et Nech.

Lors de l'étape 340, le deuxième logiciel de calcul 121A calcule donc, pour chaque période de tension d'indice k, les coefficients réel $ReI_{iA,j,k}$, et imaginaire $ImI_{iA,j,k}$ de la décomposition en série de Fourier des échantillons $IiA_{m,k}$ de chaque intensité mesurée I1A, I2A, I3A des trois phases selon les équations suivantes :

$$\text{ReI}_{iA,j,k} = \sum_{m=1}^{Nech} \text{IiA}_{m,k} \times C_{j,m}^1 \tag{21}$$

$$\text{ImI}_{iA,j,k} = \sum_{m=1}^{Nech} \text{IiA}_{m,k} \times C_{j,m}^2 \tag{22}$$

Le deuxième logiciel de calcul 121A calcule ensuite la puissance active $P_{i,j,A}$ associée à chaque rang j de la décomposition en série de Fourier grâce à l'équation :

$$P_{i,j,A,k} = \frac{(\text{Re}\,U_{i,j} \times \text{Re}\,I_{iA,j,k} + \text{Im}\,U_{i,j} \times \text{Im}\,I_{iA,j,k})}{2} \tag{23}$$

Le deuxième logiciel de calcul 121A calcule également l'énergie active $E_{i,j,A}$ associée à chaque rang j de la décomposition en série de Fourier grâce à l'équation suivant l'équation :

$$E_{i,j,A} = P_{émission} \times \sum_{k=1}^{Ntension} P_{i,j,A,k} \tag{24}$$

Le deuxième logiciel de calcul 121A calcule ensuite l'énergie active Ei,A de chacune des trois phases à partir des coefficients de Fourier de la tension et de l'intensité suivant l'équation (17).

Les autres étapes du fonctionnement de ce troisième mode de réalisation sont identiques aux étapes du premier mode de réalisation.

Les avantages de ce troisième mode de réalisation sont similaires à ceux du premier mode de réalisation.

Le système de surveillance 20 permet alors de calculer les énergies actives $E_1$, $E_2$, $E_3$ correspondant à chaque période de tension d'indice k. Le système de surveillance 20 est donc adapté à la surveillance d'installations qui sont à la fois productrices ou consommatrices de courant, et qui passent du statut de consommateur au statut de producteur, et inversement du statut de producteur au statut de consommateur, lors de durées inférieures à la période d'émission $P_{émission}$.

## Revendications

1. Dispositif électronique (60 ; 62A, ..., 62N) de surveillance d'une grandeur électrique (X) parmi une tension (U1, U2, U3) et une intensité (!1A, ..., I3N) relative à un courant alternatif circulant dans un conducteur électrique (34, 36, 38 ; 42A, 44A, 46A, ..., 42N, 44N, 46N), le courant alternatif comportant au moins une phase, le dispositif comprenant :

    - un module de mesure (66 ; 76A, ..., 76N) configuré pour mesurer au moins une valeur de la grandeur électrique (X),
    - un module d'échantillonnage (103 ; 119A ,... ,119N) configuré pour échantillonner la valeur de la grandeur électrique mesurée (X),
    - un émetteur-récepteur radioélectrique (70 ; 80A, ..., 80N),
    - un module d'émission (106; 128A, ..., 128N) relié à l'émetteur-récepteur radioélectrique (70 ; 80A, ..., 80N), le module d'émission (106; 128A, ..., 128N) étant configuré pour émettre des messages de données (M1 ; M2A, ..., M2N) à destination d'un autre dispositif électronique, avec une période d'émission (P_émission) séparant les instants d'émission de deux messages de données successifs, chaque message de données (M1 ; M2A, ..., M2N) contenant un ensemble d'au moins un paramètre de surveillance de la grandeur (X) mesurée, ledit ensemble comprenant des coefficients d'une transformée des valeurs mesurées,
- un module (104; 123A,...,123N) de détermination d'une première table (TABLE_1) et d'une deuxième table (TABLE_2), et un module (105 ; 121A,... 121N) de calcul configuré pour calculer au moins un paramètre de surveillance de la grandeur (X) à partir de la première table (TABLE_1), de la deuxième table (TABLE_2), et d'échantillons de la grandeur (X), issus du module d'échantillonnage (103, 119A ..., 119N),
la première table (TABLE_1) contenant une pluralité de premiers coefficients ($C^1_{j,m}$), chaque premier coefficient ($C^1_{j,m}$) étant fonction d'un cosinus et dépendant de la fréquence F de la tension du conducteur électrique (34, 36, 38 ; 42A, 44A, 46A, ..., 42N, 44N, 46N), et
la deuxième table (TABLE_2) contenant une pluralité de deuxièmes coefficients ($C^2_{j,m}$), chaque deuxième coefficient ($C^2_{j,m}$) étant fonction d'un sinus et dépendant de ladite fréquence F,
le dispositif étant **caractérisé en ce que** le nombre de coefficients ($C^1_{j,m}$, $C^2_{j,m}$) de chaque table (TABLE_1, TABLE_2) est égal au nombre d'échantillons de la grandeur (X) lors de la période d'émission ($P_{émission}$) et la période d'émission ($P_{émission}$) correspondant à un multiple ($N_{tension}$) de périodes de tension ($P_{tension}$), le multiple ($N_{tension}$) étant un nombre réel de valeur strictement supérieure à 1,
le nombre d'échantillons de la grandeur (X) lors de la période d'émission ($P_{émission}$) étant égal à la période d'émission ($P_{émission}$) divisée par la période de tension ($P_{tension}$) et multipliée par un nombre d'échantillons de la grandeur (X) mesurés par période de tension ($P_{tension}$),
les première et seconde tables étant calculées pour toute la période d'émission ($P_{émission}$).

2. Dispositif selon la revendication 1, dans lequel les premiers coefficients ($C^1_{j,m}$) vérifient l'équation :

$$\mathrm{C}^1_{j,m} = \cos(2 \times \Pi \times \mathrm{F} \times j \times m \times P_{ech})$$ , et

les deuxièmes coefficients ($C^2_{j,m}$) vérifiant l'équation :

$$\mathrm{C}^2_{j,m} = \sin(2 \times \Pi \times \mathrm{F} \times j \times m \times P_{ech})$$

où :

j est compris entre 1 et J, J étant un nombre entier, de préférence supérieur ou égal à 5,
$P_{ech}$ est la période d'échantillonnage de la grandeur (X), et
m est un indice d'échantillon variant entre 1 et Ntotal_ech, Ntotal_ech étant un nombre entier représentant le nombre d'échantillons de la grandeur (X) lors de la période d'émission ($P_{émission}$).

3. Dispositif (60 ; 62A, ..., 62N) selon la revendication 1 ou 2, dans lequel le module de détermination (104 ; 123A, ... ,123N) est configuré pour recalculer, lors de chaque période d'émission ($P_{émission}$), la première table (TABLE_1) et la deuxième table (TABLE_2) à partir d'une valeur de la fréquence F mesurée lors de l'avant-dernière période d'émission ($P_{émission}$).

4. Dispositif (60 ; 62A, ..., 62N) selon l'une quelconque des revendications 1 à 3, dans lequel le module d'échantillonnage (103 ; 119A,... ,119N) est configuré pour échantillonner la grandeur électrique (X) avec une période d'échantillonnage ($P_{ech}$), et la valeur de la période d'échantillonnage ($P_{ech}$) est fonction d'une valeur de la fréquence F de la tension mesurée lors de l'avant-dernière période d'émission ($P_{émission}$).

5. Dispositif (60) selon l'une quelconque des revendications 1 à 4, dans lequel le dispositif (60) est configuré pour surveiller la tension (U1, U2, U3) du conducteur électrique (34, 36, 38), le module de mesure (66) est configuré pour mesurer la fréquence F de la tension, et le message émis (M1) contient en outre une valeur mesurée de la fréquence F de la tension.

6. Dispositif (60) selon la revendication 5, dans lequel le module de mesure (66) est configuré pour calculer, pour chaque échantillon de tension ($U_{i,m}$), les parties réelle ($ReP_{i,m}$) et imaginaire ($ImP_{i,m}$) d'un phaseur de tension ($P_{i,m}$) correspondant vérifiant les équations :

$$\operatorname{Re} P_{i,m} = \frac{\sqrt{2}}{Nech} \sum_{n=0}^{Nech-1} U_{i,m+n} \cos\left(\frac{2\Pi n}{Nech}\right) \; ;$$

et

$$\mathrm{Im}\, P_{i,m} = \frac{-\sqrt{2}}{Nech} \sum_{n=0}^{Nech-1} U_{i,m+n} \sin\left(\frac{2\Pi n}{Nech}\right)$$

où Nech est le nombre d'échantillons de tension acquis pendant une période de tension (P$_{tension}$), la période de tension (P$_{tension}$) étant égale à l'inverse de la fréquence F, m est un indice d'échantillon variant entre 1 et Ntotal_ech, Ntotal_ech étant un nombre entier représentant le nombre d'échantillons de la grandeur (X) lors de la période d'émission (P$_{émission}$), et i est un indice de la phase correspondante,
le module de mesure (66) étant, en outre, configuré pour mesurer, avec une période de mesure (P$_{mesure}$), une valeur de la fréquence F à partir de deux phaseurs (P$_{i,m}$) de tension correspondant respectivement à deux instants temporels séparés temporellement d'une période de mesure (P$_{mesure}$).

7.  Dispositif (60) selon la revendication 6, dans lequel la période de mesure (P$_{mesure}$) est sensiblement égale à la moitié de la période de tension (P$_{tension}$).

8.  Dispositif (62A, ..., 62N) selon l'une quelconque des revendications 1 à 4, dans lequel le dispositif (62A, ..., 62N) est configuré pour surveiller une intensité (I1A, ..., I3N), et comporte un module de réception (120A,...,120N) d'un message de données (M1) comprenant une valeur mesurée de la fréquence F de la tension.

9.  Système électronique (20) de surveillance d'un tableau électrique (16), le tableau électrique (16) comportant au moins un conducteur électrique primaire de départ (34, 36, 38) et au moins un conducteur électrique secondaire de départ (42A, ..., 46N), le ou chaque conducteur secondaire de départ (42A, ..., 46N) étant connecté électriquement à un conducteur primaire de départ (34, 36, 38) correspondant, les conducteurs de départ (34, 42A, 42B, .., 38, 46A, 46B, ..., 46N) correspondants présentent une tension alternative, le système comprenant :

    - un premier dispositif électronique (60 ) de surveillance de la tension (U1, U2, U3) de chaque conducteur électrique primaire de départ (34, 36, 38),
    - au moins un deuxième dispositif électronique (62A, ..., 62N) de surveillance de l'intensité (I1A, ..., I3N) du courant alternatif circulant dans chaque conducteur électrique secondaire (42A, ..., 46N),

    **caractérisé en ce que** le premier dispositif électronique (60) de surveillance est selon l'une quelconque des revendications 1 à 7 et le au moins un deuxième dispositif électronique (62A, ..., 62N) de surveillance est selon l'une quelconque des revendications 1 à 4 et 8.

10. Système (20) selon la revendication 9, dans lequel chaque dispositif électronique de surveillance (60 ; 62A, ..., 62N) est selon l'une quelconque des revendications 1 à 4.

11. Système (20) selon la revendication 9, dans lequel le premier dispositif de surveillance (60) est selon l'une quelconque des revendications 5 à 7, et chaque deuxième dispositif de surveillance (62A, ..., 62N) est selon la revendication 8.

12. Système (20) selon la revendication 9, dans lequel le premier dispositif de surveillance (60) est selon l'une quelconque des revendications 1 à 7, et chaque deuxième dispositif de surveillance (62A, ..., 62N) comprend en outre un module de détermination (123A,...,123N) configuré pour calculer une troisième table de corrélation (TABLE_3) et une quatrième table de corrélation (TABLE _4),

    la troisième table (TABLE_3) contenant une pluralité des premiers coefficients (C1$_{j,m}$), et
    la quatrième table (TABLE_4) contenant une pluralité des deuxièmes coefficients (C2j,m),
    le nombre de coefficients (C1$_{j,m}$, C2$_{j,m}$) de chacune de la troisième table (TABLE_3) et de la quatrième table (TABLE_4) étant égal au nombre d'échantillons de la grandeur (X) lors d'une période de tension (P$_{tension}$) correspondante.

13. Armoire électrique, comprenant :

    - un tableau électrique (16) comportant au moins un conducteur électrique primaire de départ (34, 36, 38) et au moins un conducteur électrique secondaire de départ (42A, ..., 46N), le ou chaque conducteur secondaire de départ (42A, ..., 46N) étant connecté électriquement à un conducteur primaire de départ (34 ; 36 ; 38) correspondant, les conducteurs de départ (34, 42A, 42B, .., 38, 46A, 46B, ..., 46N) correspondants présentant une tension alternative, et
- un système (20) de surveillance du tableau électrique (16),

**caractérisé en ce que** le système de surveillance (20) est selon l'une quelconque des revendications 9 à 12.

14. Poste (10) de transformation d'un courant électrique présentant une première tension alternative en un courant électrique présentant une deuxième tension alternative, **caractérisé en ce qu'**il comprend une armoire électrique selon la revendication 13, un tableau d'arrivée (14) comportant au moins un conducteur électrique d'arrivée (24A, 26A, 28A, 24B, 26B, 28B) propre à être relié à un réseau électrique (12), le conducteur d'arrivée présentant la première tension alternative, le tableau (16) de l'armoire formant un tableau de départ dont les conducteurs de départ (34, 42A, 42B, .., 38, 46A, 46B, ..., 46N) correspondants présentent la deuxième tension alternative, et un transformateur électrique (18) connecté entre le tableau d'arrivée (14) et le tableau de départ (16), le transformateur (18) étant propre à transformer le courant présentant la première tension alternative en le courant présentant la deuxième tension alternative.

15. Procédé de surveillance d'une grandeur électrique (X) parmi une tension (U1, U2, U3) et une intensité (I1A, ..., I3N) relative à un courant alternatif circulant dans un conducteur électrique (34, 36, 38 ; 42A, 44A, 46A, ..., 42N, 44N, 46N), le courant alternatif comportant au moins une phase,

le procédé étant mis en oeuvre par un dispositif électronique de surveillance (60 ; 62A, ..., 62N), et comprenant les étapes suivantes :

- b) la mesure (210 ; 330) d'au moins une valeur de la grandeur électrique (X) et l'échantillonnage de la valeur mesurée (X),
- d) l'émission (230 ; 350) de messages de données (M1 ; M2A, ..., M2N), avec une période d'émission ($P_{émission}$) séparant les instants d'émission de deux messages de données successifs, chaque message de données (M1 ; M2A, ..., M2N) contenant un ensemble d'au moins un paramètre de surveillance de la grandeur mesurée, à destination d'un autre dispositif électronique (62A, ..., 62N ; 60 ; 64), ledit ensemble comprenant des coefficients d'une transformée des valeurs mesurées, préalablement à l'étape b), l'étape suivante :
- a) la détermination d'une première table (TABLE_1) et d'une deuxième table (TABLE_2),

la première table (TABLE_1) contenant une pluralité de premiers coefficients ($C^1_{j,m}$), chaque premier coefficient ($C^1_{j,m}$) étant fonction d'un cosinus et dépendant de ladite fréquence F de la tension du conducteur électrique (34, 36, 38 ; 42A, 44A, 46A, ..., 42N, 44N, 46N), et la deuxième table (TABLE_2) contenant une pluralité de deuxièmes coefficients ($C^2_{j,m}$), chaque deuxième coefficient ($C^2_{j,m}$) étant fonction d'un sinus et dépendant de ladite fréquence F, et le procédé étant **caractérisé en ce que**
le nombre de coefficients ($C^1_{j,m}$, $C^2_{j,m}$) de chaque table (TABLE_1, TABLE_2) est égal au nombre d'échantillons de la grandeur (X) lors de la période

d'émission ($P_{émission}$) et la période d'émission ($P_{émission}$) correspondant à un multiple ($N_{tension}$) de périodes de tension ($P_{tension}$), le multiple ($N_{tension}$) étant un nombre réel de valeur strictement supérieure à 1,
le nombre d'échantillons de la grandeur (X) lors de la période d'émission ($P_{émission}$) étant égal à la période d'émission ($P_{émission}$) divisée par la période de tension ($P_{tension}$) et multipliée par un nombre d'échantillons de la grandeur X mesurés par période de tension ($P_{tension}$),
les première et seconde tables étant calculées pour toute la période d'émission ($P_{émission}$),

et **en ce qu'**il comprend, en outre, après l'étape b) et préalablement à l'étape d), l'étape suivante :

- c) le calcul d'au moins un paramètre de surveillance de la grandeur (X) à partir de la première table (TABLE_1), de la deuxième table (TABLE_2), et d'échantillons de la grandeur (X), obtenus lors de l'étape b).

EP 3 048 448 B1

**Patentansprüche**

1. Elektronische Vorrichtung (60; 62A, ..., 62N) zur Überwachung einer elektrischen Größe (X), entweder Spannung (U1, U2, U3) oder Stromstärke (I1A, ..., I3N), die sich auf einen in einem elektrischen Leiter (34, 36, 38; 42A, 44A, 46A, ..., 42N, 44N, 46N) fließenden Wechselstrom bezieht, wobei der Wechselstrom mindestens eine Phase aufweist, wobei die Vorrichtung Folgendes umfasst:

   - ein Messmodul (66; 76A, ..., 76N), das so konfiguriert ist, dass es mindestens einen Wert der elektrischen Größe (X) misst,
   - ein Probenahmemodul (103; 119A,... ,119N), das so konfiguriert ist, dass es den Wert der gemessenen elektrischen Größe (X) abtastet,
   - ein Funksende- und -empfangsgerät (70; 80A, ..., 80N),
   - ein Sendemodul (106; 128A, ..., 128N), das mit dem Funksende- und - empfangsgerät (70; 80A, ..., 80N) verbunden ist, wobei das Sendemodul (106; 128A, ..., 128N) so konfiguriert ist, dass es Datennachrichten (M1; M2A, ..., M2N) an eine andere elektronische Vorrichtung sendet, mit einer Sendeperiode ($P_{Emission}$), die die Sendezeitpunkte von zwei aufeinanderfolgenden Datennachrichten trennt, wobei jede Datennachricht (M1; M2A, ..., M2N) einen Satz von mindestens einem Überwachungsparameter der gemessenen Größe (X) enthält, wobei der Satz Koeffizienten einer Transformierung der gemessenen Werte umfasst,
   - ein Modul (104; 123A,..., 123N) zur Bestimmung einer ersten Tabelle (TABLE_1) und einer zweiten Tabelle (TABLE_2), und ein Berechnungsmodul (105; 121A,... ,121 N) das konfiguriert ist um mindestens einen Überwachungsparameter der Größe (X) aus der ersten Tabelle (TABLE_1), der zweiten Tabelle (TABLE_2) und aus Abtastungen der Größe (X), die von dem Probenahmemodul (103, 119A ..., 119N) stammen, zu berechnen,) die erste Tabelle (TABLE_1) eine Vielzahl von ersten Koeffizienten ($C^1_{j,m}$) enthält, wobei jeder erste Koeffizient ($C^1_{j,m}$) eine Funktion eines Kosinus ist und von der Frequenz F der Spannung des elektrischen Leiters (34, 36, 38; 42A, 44A, 46A, ..., 42N, 44N, 46N) abhängt, und
   die zweite Tabelle (TABLE _2) eine Vielzahl von zweiten Koeffizienten ($C^2_{j,m}$) enthält, wobei jeder zweite Koeffizient ($C^2_{j,m}$) eine Funktion eines Sinus ist und von der Frequenz F abhängt, wobei die Vorrichtung **dadurch gekennzeichnet ist, dass** die Anzahl der Koeffizienten ($C^1_{j,m}$, $C^2_{j,m}$) jeder Tabelle (TABLE_1, TABLE_2) gleich der Anzahl der Abtastungen der Größe (X) während der Sendeperiode ($P_{Emission}$) ist und die Sendeperiode ($P_{Emission}$) einem Vielfachen ($N_{Spannung}$) von Spannungsperioden ($P_{Spannung}$) entspricht, wobei das Vielfache ($N_{Spannung}$) eine reelle Zahl mit einem Wert ist, der strikt größer als 1 ist, wobei die Anzahl der Abtastungen der Größe (X) während der Sendeperiode ($P_{Emission}$) gleich der Sendeperiode ($P_{Emission}$) dividiert durch die Spannungsperiode ($P_{Spannung}$) und multipliziert mit einer Anzahl der Abtastungen der Größe (X) ist, die pro Spannungsperiode ($P_{Spannung}$) gemessen werden, wobei die erste und zweite Tabelle für die gesamte Sendeperiode ($P_{Emission}$) berechnet werden.

2. Vorrichtung nach Anspruch 1, wobei die ersten Koeffizienten ($C^1_{j,m}$) folgende Gleichung erfüllen: $C^1_{j,m} = \cos(2 \times \Pi \times F \times j \times m \times P_{ech})$, und die zweiten Koeffizienten ($C^2_{j,m}$), die Gleichung:

$$C^1_{j,m} = \sin(2 \times \Pi \times F \times j \times m \times P_{ech}),$$

   wobei:

   j zwischen 1 und J liegt, wobei J eine ganze Zahl ist, vorzugsweise größer oder gleich 5,
   $P_{ech}$ die Abtastperiode der Größe (X) ist, und
   m ein Probenindex ist, der zwischen 1 und Ntotal_ech variiert, wobei Ntotal_ech eine ganze Zahl ist, die die Anzahl der Abtastungen der Größe (X) während der Sendeperiode ($P_{Emission}$) darstellt.

3. Vorrichtung (60; 62A, ...,62N) nach Anspruch 1 oder 2, wobei das Bestimmungsmodul (104; 123A, ... ,123N) so konfiguriert ist, dass es in jeder Sendeperiode ($P_{Emission}$) die erste Tabelle (TABLE_1) und die zweite Tabelle (TABLE_2) aus einem Wert der Frequenz F neu berechnet, der während der vorletzten Sendeperiode ($P_{Emission}$) gemessen wurde.

4. Vorrichtung (60 ; 62A, ..., 62N) nach einem der Ansprüche 1 bis 3, wobei das Probenahmemodul (103; 119A,... ,119N) so konfiguriert ist, dass es die elektrische Größe (X) mit einer Abtastperiode ($P_{ech}$) abtastet, und der Wert der Abtastperiode ($P_{ech}$) von einem Wert der Frequenz F der Spannung abhängt, die in der vorletzten Sendeperiode ($P_{Emission}$) gemessen wurde.

5.  Vorrichtung (60) nach einem der Ansprüche 1 bis 4, wobei die Vorrichtung (60) so konfiguriert ist, dass sie die Spannung (U1, U2, U3) des elektrischen Leiters (34, 36, 38) überwacht, das Messmodul (66) konfiguriert ist, um die Frequenz F der Spannung zu messen, und die gesendete Nachricht (M1) außerdem einen gemessenen Wert der Frequenz F der Spannung enthält.

6.  Vorrichtung (60) nach Anspruch 5, wobei das Messmodul (66) so konfiguriert ist, dass es für jeden Spannungsabtastwert ($U_{i,m}$), den Realteil ($ReP_{i,m}$) und den Imaginärteil ($ImP_{i,m}$) eines entsprechenden Spannungsphasers ($P_{i,m}$) berechnet, der die Gleichungen überprüft:

$$\operatorname{Re} P_{i,m} = \frac{\sqrt{2}}{Nech} \sum_{n=0}^{Nech-1} U_{i,m+n} \cos\left(\frac{2\Pi n}{Nech}\right) ;$$

und

$$\operatorname{Im} P_{i,m} = \frac{-\sqrt{2}}{Nech} \sum_{n=0}^{Nech-1} U_{i,m+n} \sin\left(\frac{2\Pi n}{Nech}\right)$$

wobei Nech die Anzahl der Abtastungen der Spannung ist, die während einer Spannungsperiode ($P_{Spannung}$) erhalten wird, wobei die Spannungsperiode ($P_{Spannung}$) dem Umgekehrten der Frequenz F entspricht, m ist ein Probenindex, der zwischen 1 und Ntotal_ech variiert, wobei Ntotal_ech eine ganze Zahl ist, die die Anzahl der Abtastwerte der Größe (X) während der Sendeperiode ($P_{Emission}$) darstellt, und i ein Index der entsprechenden Phase ist,
wobei das Messmodul (66) außerdem so konfiguriert ist, dass es mit einer Messperiode ($P_{Messung}$) einen Wert der Frequenz F ausgehend von zwei Spannungsphasern ($P_{i,m}$) misst, die jeweils zwei zeitlich getrennten Zeitpunkten einer Messperiode ($P_{Messung}$) entsprechen.

7.  Vorrichtung (60) nach Anspruch 6, wobei die Messperiode ($P_{Messung}$) im Wesentlichen gleich der Hälfte der Spannungsperiode ($P_{Spannung}$) ist.

8.  Vorrichtung (62A, ..., 62N) nach einem der Ansprüche 1 bis 4, wobei die Vorrichtung (62A, ..., 62N) so konfiguriert ist, dass sie einen Strom (I1A, ..., I3N) überwacht und ein Modul (120A, ..., 120N) zum Empfangen einer Datennachricht (M1) aufweist, die einen Messwert der Frequenz F der Spannung enthält.

9.  Elektronisches System (20) zur Überwachung einer elektrischen Schalttafel (16), wobei die elektrische Schalttafel (16) mindestens einen primären elektrischen Abgangsleiter (34, 36, 38) und mindestens einen sekundären elektrischen Abgangsleiter (42A, ..., 46N) aufweist, wobei der oder jeder sekundäre Abgangsleiter (42A, ..., 46N) elektrisch mit einem entsprechenden primären Abgangsleiter (34, 36, 38) verbunden ist, wobei die entsprechenden Abgangsleiter (34, 42A, 42B, ..., 38, 46A, 46B, ..., 46N) eine Wechselspannung aufweisen, wobei das System Folgendes umfasst:

    - eine erste elektronische Vorrichtung (60) zur Überwachung der Spannung (U1, U2, U3) jedes primären elektrischen Abgangsleiters (34, 36, 38),
    - mindestens eine zweite elektronische Vorrichtung (62A, ..., 62N) zur Überwachung der Intensität (I1A, ..., I3N) des Wechselstroms, der durch jeden sekundären elektrischen Leiter (42A, ..., 46N) fließt,

    **dadurch gekennzeichnet, dass** die erste elektronische Überwachungsvorrichtung (60) gemäß einem der Ansprüche 1 bis 7 ist und die mindestens eine zweite elektronische Überwachungsvorrichtung (62A, ..., 62N) gemäß einem der Ansprüche 1 bis 4 und 8 ist.

10. System (20) nach Anspruch 9, wobei jede elektronische Überwachungsvorrichtung (60; 62A, ..., 62N) nach einem der Ansprüche 1 bis 4 ist.

**11.** System (20) nach Anspruch 9, wobei die erste Überwachungsvorrichtung (60) gemäß einem der Ansprüche 5 bis 7 ist und jede zweite Überwachungsvorrichtung (62A, ..., 62N) gemäß Anspruch 8 ist.

**12.** System (20) nach Anspruch 9, wobei die erste Überwachungsvorrichtung (60) nach einem der Ansprüche 1 bis 7 ist, und jede zweite Überwachungsvorrichtung (62A, ...., 62N) ferner ein Bestimmungsmodul (123A, ..., 123N) umfasst, das konfiguriert ist, um eine dritte Korrelationstabelle (TABLE_3) und eine vierte Korrelationstabelle (TABLE_4) zu berechnen,

> die dritte Tabelle (TABLE_3) eine Vielzahl der ersten Koeffizienten ($C^1_{j,m}$) enthält, und
> die vierte Tabelle (TABLE_4) eine Vielzahl der zweiten Koeffizienten ($C^2_{j,m}$) enthält,
> wobei die Anzahl der Koeffizienten ($C^1_{j,m}$, $C^2_{j,m}$) sowohl der dritten Tabelle (TABLE_3) als auch der vierten Tabelle (TABLE_4) gleich der Anzahl von Abtastungen der Größe (X) während einer entsprechenden Spannungsperiode ($P_{Spannung}$) ist.

**13.** Schaltschrank, bestehend aus:

> - - einer elektrischen Schalttafel (16), umfassend mindestens einen primären elektrischen Abgangsleiter (34, 36, 38) und mindestens einen sekundären elektrischen Abgangsleiter (42A, ..., 46N), wobei der oder jeder sekundäre Abgangsleiter (42A, ..., 46N) elektrisch mit einem entsprechenden primären Abgangsleiter (34; 36; 38) verbunden ist, wobei die entsprechenden Abgangsleiter (34, 42A, 42B, ..., 38, 46A, 46B, ..., 46N) eine Wechselspannung aufweisen und
> - ein System (20) zur Überwachung der elektrischen Schalttafel (16),

> **dadurch gekennzeichnet, dass** das System (20) zur Überwachung nach einem der Ansprüche 9 bis 12 ist.

**14.** Station (10) zur Umwandlung eines elektrischen Stroms, der eine erste Wechselspannung aufweist, in einen elektrischen Strom, der eine zweite Wechselspannung aufweist, **dadurch gekennzeichnet, dass** sie einen Schaltschrank nach Anspruch 13, eine Ankunftstafel (14) mit mindestens einem Zuleitungsleiter (24A, 26A, 28A, 24B, 26B, 28B), der mit einem Stromnetz (12) verbunden werden kann, wobei der Zuleitungsleiter eine erste Wechselspannung aufweist, wobei die Schalttafel (16) des Schranks eine Abgangstafel bildet, deren Abgangsleiter (34, 42A, 42B, .., 38, 46A, 46B, ..., 46N) die zweite Wechselspannung aufweisen, und

> - einen elektrischen Transformator (18), der zwischen der Ankunftstafel (14) und der Abgangstafel (16) angeschlossen ist, wobei der Transformator (18) geeignet ist, um den Strom, der die erste Wechselspannung aufweist in den Strom umzuwandeln, der die zweite Wechselspannung aufweist, und

**15.** Verfahren zur Überwachung einer elektrischen Größe (X) aus einer Spannung (U1, U2, U3) und einer Stromstärke (I1A, ..., I3N) in Bezug auf einen Wechselstrom, der in einem elektrischen Leiter (34, 36, 38; 42A, 44A, 46A, ..., 42N, 44N, 46N) fließt, wobei der Wechselstrom mindestens eine Phase umfasst,

> wobei das Verfahren von einer elektronischen Überwachungsvorrichtung (60 ; 62A, ..., 62N) implementiert ist und Folgendes umfasst:

> > - b) Messen (210; 330) von mindestens einem Wert der elektrischen Größe (X) und Abtasten des gemessenen Wertes (X),
> > - d) Senden (230; 350) von Datennachrichten (M1; M2A, ..., M2N), mit einer Sendeperiode ($P_{Emission}$), die die Sendezeitpunkte von zwei aufeinanderfolgenden Datennachrichten trennt, wobei jede Datennachricht (M1; M2A, ..., ..., M2N) einen Satz von mindestens einem Überwachungsparameter der gemessenen Größe an eine andere elektronische Vorrichtung (62A, ..., 62N; 60; 64) enthält, wobei der Satz Koeffizienten einer Transformierung der gemessenen Werte umfasst,

> vor dem Schritt b) den folgenden Schritt:

> > - a) Bestimmen einer ersten Tabelle (TABLE_1) und einer zweiten Tabelle (TABLE_2),

> > > wobei die erste Tabelle (TABLE_1) eine Vielzahl von ersten Koeffizienten ($C^1_{j,m}$) enthält, wobei jeder erste Koeffizient ($C^1_{j,m}$) eine Funktion eines Kosinus ist und von der Frequenz F der Spannung des elektrischen Leiters (34, 36, 38; 42A, 44A, 46A, ..., 42N, 44N, 46N) abhängt, und

**EP 3 048 448 B1**

die zweite Tabelle (TABLE_2) eine Vielzahl von zweiten Koeffizienten ($C^2_{j,m}$) enthält, wobei jeder zweite Koeffizient ($C^2_{j,m}$) eine Funktion eines Sinus ist und von der Frequenz F abhängt, und wobei das Verfahren **dadurch gekennzeichnet ist, dass** die Anzahl der Koeffizienten ($C^1_{j,m}$, $C^2_{j,m}$) jeder Tabelle (TABLE_1, TABLE_2) der Anzahl der Abtastungen der Größe (X) während der Sendeperiode ($P_{Emission}$) entspricht und die Sendeperiode ($P_{Emission}$) einem Vielfachen ($N_{Spannung}$) von Spannungsperioden ($P_{Spannung}$), wobei das Vielfache ($N_{Spannung}$) eine reelle Zahl mit einem Wert ist, der strikt größer als 1 ist, wobei die Anzahl der Abtastungen der Größe (X) während der Sendeperiode ($P_{Emission}$) gleich der Sendeperiode ($P_{Emission}$) dividiert durch die Spannungsperiode ($P_{Spannung}$) und multipliziert mit einer Anzahl der Abtastungen der Größe X, die pro Spannungsperiode ($P_{Spannung}$) gemessen werden, wobei die erste und zweite Tabelle für die gesamte Sendeperiode ($P_{Emission}$) berechnet werden,

und dadurch, dass es nach Schritt b) und vor Schritt d) außerdem den folgenden Schritt umfasst:

- c) Berechnen von mindestens einem Überwachungsparameter der Größe (X) aus der ersten Tabelle (TABLE_1), der zweiten Tabelle (TABLE_2) und Abtastungen der Größe (X), die in Schritt b) erhalten wurden.

**Claims**

1. An electronic device (60; 62A, ..., 62N) for monitoring an electrical quantity (X) from among a voltage (U1, U2, U3) and a current (I1A, ..., I3N) relating to an alternating current flowing in an electrical conductor (34, 36, 38; 42A, 44A, 46A, ..., 42N, 44N, 46N), the alternating current having at least one phase, the device comprising:

   - a measurement module (66; 76A, ..., 76N) configured to measure at least one value of the electrical quantity (X),
   - a sampling module (103; 119A,... , 119N) configured to sample the value of the measured electrical quantity (X),
   - a radio transceiver (70; 80A, ..., 80N),
   - a transmission module (106; 128A, ..., 128N) connected to the radio transceiver (70; 80A, ..., 80N), the transmission module (106; 128A, ..., 128N) being configured to transmit data messages (M1; M2A, ..., M2N) to another electronic device, with a transmission period ($P_{transmission}$) separating the instants of transmission of two successive data messages, each data message (M1; M2A, ..., M2N) containing a set of at least one parameter for monitoring the quantity (X) measured, said set comprising coefficients of a transform of the measured values,
   - a module (104; 123A,...,123N) for determining a first table (TABLE_1) and a second table (TABLE_2), and a module (105; 121A,... 121 N) configured to calculate at least one parameter for monitoring the quantity (X) on the basis of the first table (TABLE_1), the second table (TABLE_2), and samples of the quantity (X), taken from the sampling module (103, 119A ..., 119N),
   the first table (TABLE_1) containing a plurality of first coefficients ($C^1_{j,m}$), each first coefficient ($C^1_{j,m}$) being a function of a cosine and dependent on the frequency F of the voltage of the electrical conductor (34, 36, 38; 42A, 44A, 46A, ..., 42N, 44N, 46N), and
   the second table (TABLE_2) containing a plurality of second coefficients ($C^2_{j,m}$), each second coefficient ($C^2_{j,m}$) being a function of a sine and dependent on said frequency F,
   the device being **characterised in that** the number of coefficients ($C^1_{j,m}$, $C^2_{j,m}$) of each table (TABLE_1, TABLE_2) is equal to the number of samples of the quantity (X) during the transmission period ($P_{transmission}$) and the transmission period ($P_{transmission}$) corresponding to a multiple ($N_{voltage}$) of voltage periods ($P_{voltage}$), the multiple ($N_{voltage}$) being a real number with a value strictly greater than 1, the number of samples of the quantity (X) during the transmission period ($P_{transmission}$) being equal to the transmission period ($P_{transmission}$) divided by the voltage period ($P_{voltage}$) and multiplied by a number of samples of the quantity (X) measured per voltage period ($P_{voltage}$), the first and second tables being calculated for the entire broadcast period ($P_{transmission}$).

2. A device according to claim 1, in which the first coefficients ($C^1_{j,m}$) satisfy the equation: $C^1_{j,m}= \cos(2 \times \Pi \times F \times j \times m \times P_{ech})$, and
   the second coefficients ($C^2_{j,m}$) satisfying equation:

$$C^2_{j,m}= \sin(2 \times \Pi \times F \times j \times m \times P_{ech}),$$

22

where:

j is between 1 and J, J being an integer, preferably greater than or equal to 5,
Pech is the sampling period of the quantity (X), and
m is a sample index varying between 1 and Ntotal_ech, Ntotal_ech being an integer representing the number of samples of the quantity (X) during the transmission period ($P_{transmission}$).

3. A device (60; 62A, ..., 62N) according to claim 1 or 2, in which the determination module (104; 123A, ... 123N) is configured to recalculate, during each transmission period ($P_{transmission}$), the first table (TABLE_1) and the second table (TABLE_2) from a value of the frequency F measured during the penultimate transmission period ($P_{transmission}$).

4. A device (60; 62A, ..., 62N) according to any one of claims 1 to 3, in which the sampling module (103; 119A, ... 119N) is configured to sample the electrical quantity (X) with a sampling period ($P_{ech}$), and the value of the sampling period ($P_{ech}$) is a function of a value of the frequency F of the voltage measured during the penultimate transmission period ($P_{transmission}$).

5. A device (60) according to any one of claims 1 to 4, wherein the device (60) is configured to monitor the voltage (U1, U2, U3) of the electrical conductor (34, 36, 38), the measurement module (66) is configured to measure the frequency F of the voltage, and the transmitted message (M1) further contains a measured value of the frequency F of the voltage.

6. A device (60) according to claim 5, in which the measurement module (66) is configured to calculate, for each voltage sample ($U_{i,m}$), the real ($ReP_{i,m}$) and imaginary ($ImP_{i,m}$) parts of a corresponding voltage phasor ($P_{i,m}$) satisfying the equations:

$$\operatorname{Re} P_{i,m} = \frac{\sqrt{2}}{Nech} \sum_{n=0}^{Nech-1} U_{i,m+n} \cos\left(\frac{2\Pi n}{Nech}\right) \; ;$$

and

$$\operatorname{Im} P_{i,m} = \frac{-\sqrt{2}}{Nech} \sum_{n=0}^{Nech-1} U_{i,m+n} \sin\left(\frac{2\Pi n}{Nech}\right)$$

where Nech is the number of voltage samples acquired during a voltage period ($P_{voltage}$), the voltage period ($P_{voltage}$) being equal to the reciprocal of the frequency F, m is a sample index varying between 1 and Ntotal_ech, Ntotal_ech being an integer representing the number of samples of the quantity (X) during the transmission period ($P_{transmission}$), and i is the number of samples of the corresponding phase,
the measurement module (66) also being configured to measure, with a measurement period ($P_{measurement}$), a value of the frequency F from two voltage phasors ($P_{i,m}$) corresponding respectively to two temporally separated instants of a measurement period ($P_{measurement}$).

7. A device (60) as claimed in claim 6, in which the measurement period ($P_{measurement}$) is substantially equal to half the voltage period ($P_{voltage}$).

8. A device (62A, ..., 62N) according to any one of claims 1 to 4, in which the device (62A, ..., 62N) is configured to monitor a current (I1A, ..., I3N), and comprises a module (120A, ..., 120N) for receiving a data message (M1) comprising a measured value of the frequency F of the voltage.

9. An electronic system (20) for monitoring an electrical panel (16), the electrical panel (16) comprising at least one primary outgoing electrical conductor (34, 36, 38) and at least one secondary outgoing electrical conductor (42A, ...46N), the or each outgoing secondary conductor (42A, ..., 46N) being electrically connected to a corresponding outgoing primary conductor (34, 36, 38), the corresponding outgoing conductors (34, 42A, 42B, ..., 38, 46A, 46B, ..., 46N) having an AC voltage, the system comprising:

- a first electronic device (60) for monitoring the voltage (U1, U2, U3) of each outgoing primary electrical conductor (34, 36, 38),
- at least one second electronic device (62A, ..., 62N) for monitoring the current (I1A, ..., I3N) of the alternating current flowing in each secondary electrical conductor (42A, ..., 46N),

**characterised in that** the first electronic monitoring device (60) is according to any one of claims 1 to 7 and the at least one second electronic monitoring device (62A, ..., 62N) is according to any one of claims 1 to 4 and 8.

10. A system (20) as claimed in claim 9, wherein each electronic monitoring device (60; 62A, ..., 62N) is as claimed in any one of claims 1 to 4.

11. A system (20) according to claim 9, wherein the first monitoring device (60) is according to any one of claims 5 to 7, and each second monitoring device (62A, ..., 62N) is according to claim 8.

12. A system (20) according to claim 9, wherein the first monitoring device (60) is according to any one of claims 1 to 7, and each second monitoring device (62A, ...., 62N) further comprises a determination module (123A, ..., 123N) configured to calculate a third correlation table (TABLE 3) and a fourth correlation table (TABLE _4),

the third table (TABLE_3) containing a plurality of first coefficients ($C^1_{j,m}$), and
the fourth table (TABLE_4) containing a plurality of second coefficients ($C^2_{j,m}$),
the number of coefficients ($C^1_{j,m}$, $C^2_{j,m}$) of each of the third table (TABLE_3) and the fourth table (TABLE_4) being equal to the number of samples of the quantity (X) during a corresponding voltage period ($P_{voltage}$).

13. Electrical cabinet, comprising:

- an electrical panel (16) comprising at least one primary outgoing electrical conductor (34, 36, 38) and at least one secondary outgoing electrical conductor (42A, ..., 46N), the or each secondary outgoing conductor (42A, ...., 46N) being electrically connected to a corresponding primary outgoing conductor (34; 36; 38), the corresponding outgoing conductors (34, 42A, 42B, ..., 38, 46A, 46B, ..., 46N) having an AC voltage, and
- a system (20) for monitoring the electrical panel (16),

**characterized in that** the surveillance system (20) is according to any of the claims 9 to 12.

14. A substation (10) for transforming an electric current having a first alternating voltage into an electric current having a second alternating voltage, the substation being **characterized in that** it comprises an electrical cabinet as defined in claim 13, an input panel (14) including at least one electrical input conductor (24A, 26A, 28A, 24B, 26B, 28B) suitable for being connected to an electrical network (12), the incoming conductor having the second alternating voltage, the panel (16) of the cabinet forming an outgoing panel whose corresponding outgoing conductors (34, 42A, 42B, 38, 46A, 46B, ..., 46N) have the second AC voltage, and
an electrical transformer (18) connected between the incoming panel (14) and the outgoing panel (16), the transformer (18) being suitable for transforming the current having the first alternating voltage into the current having the second alternating voltage.

15. A method of monitoring an electrical quantity (X) from among a voltage (U1, U2, U3) and a current (I1A, ..., I3N) relating to an alternating current flowing in an electrical conductor (34, 36, 38; 42A, 44A, 46A, ..., 42N, 44N, 46N), the alternating current comprising at least one phase,

the method being implemented by an electronic monitoring device (60; 62A, ..., 62N), and comprising the following steps:

- b) measuring (210; 330) at least one value of the electrical quantity (X) and sampling the measured value (X),
- d) transmission (230; 350) of data messages (M1; M2A, ..., M2N), with a transmission period ($P_{transmission}$) separating the instants of transmission of two successive data messages, each data message (M1; M2A, ..., M2N) containing a set of at least one parameter for monitoring the measured quantity, intended for another electronic device (62A, ..., 62N; 60; 64), the said set comprising coefficients of a transform of the measured values,

prior to step b), the following step:

- a) determining a first table (TABLE_1) and a second table (TABLE_2),

the first table (TABLE_1) containing a plurality of first coefficients ($C^1_{j,m}$), each first coefficient ($C^1_{j,m}$) being a function of a cosine and dependent on said frequency F of the voltage of the electrical conductor (34, 36, 38; 42A, 44A, 46A, ..., 42N, 44N, 46N), and
the second table (TABLE_2) containing a plurality of second coefficients ($C^2_{j,m}$), each second coefficient ($C^2_{j,m}$) being a function of a sine and being derived from said frequency F, and the method being **characterised in that** the number of coefficients ($C^1_{j,m}$, $C^2_{j,m}$) of each table (TABLE_1, TABLE_2) is equal to the number of samples of the quantity (X) during the transmission period ($P_{transmission}$) and the transmission period ($P_{transmission}$) corresponding to a multiple ($N_{voltage}$) of voltage periods ($P_{voltage}$), the multiple ($N_{voltage}$) being a real number with a value strictly greater than 1, the number of samples of the quantity (X) during the transmission period ($P_{transmission}$) being equal to the transmission period ($P_{transmission}$) divided by the voltage period ($P_{voltage}$) and multiplied by a number of samples of the quantity X measured per voltage period ($P_{voltage}$), the first and second tables being calculated for the entire transmitting period (Ptransmission),

and **in that** it further comprises, after step b) and prior to step d), the following step:

- c) calculating at least one parameter for monitoring the quantity (X) from the first table (TABLE_1), the second table (TABLE_2) and samples of the quantity (X) obtained in step b).

FIG.1

FIG.2

EP 3 048 448 B1

FIG.3

```
                    ┌─────────────────────────┐
                    │      Initialisation      │────── 200
                    └─────────────────────────┘
                                 │
                                 ▼
                    ┌─────────────────────────┐
            ┌──────▶│      Transmission d'une  │────── 205
            │       │      valeur de fréquence │
            │       └─────────────────────────┘
            │                    │
            │                    ▼
            │       ┌─────────────────────────┐
            │       │   Adaptation de la       │────── 208
            │       │   fréquence              │
            │       │   d'échantillonage       │
            │       └─────────────────────────┘
            │                    │
            │                    ▼
            │       ┌─────────────────────────┐
            │       │     Mesure de la tension │────── 210
            │       └─────────────────────────┘
            │                    │
            │                    ▼
            │       ┌─────────────────────────┐
            │       │ Compression de la tension│
            │       │ mesurée, et élaboration  │──── 220
            │       │ du premier message M1    │
            │       └─────────────────────────┘
            │                    │
            │                    ▼
            │       ┌─────────────────────────┐──── 230
            └───────│ Emission du premier      │
                    │ message M1               │
                    └─────────────────────────┘
```

# FIG.4

FIG.5

**FIG.6**

**FIG.7**

FIG.8

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013017663 A1

- FR 2991057 A1